# EUROPÄISCHE PATENTSCHRIFT

(11) **EP 2 906 961 B1**
(45) Veröffentlichungstag und Bekanntmachung des Hinweises auf die Patenterteilung: **24.08.2016**
(21) Anmeldenummer: 14786816.0
(22) Anmeldetag: 02.10.2014
(51) Int. Cl.: G01R 33/3815, H01F 6/06, H01L 39/14

(54) **NMR-SPEKTROMETER UMFASSEND EINE SUPRALEITENDE MAGNETSPULE MIT WICKLUNGEN AUS EINER SUPRALEITERSTRUKTUR MIT VERKETTETEN BANDSTÜCKEN**
NMR SPECTROMETER COMPRISING A SUPERCONDUCTING MAGNETIC COIL HAVING WINDINGS COMPOSED OF A SUPERCONDUCTOR STRUCTURE HAVING STRIP PIECES CHAINED TOGETHER
SPECTROMÈTRE RMN COMPRENANT UNE BOBINE ÉLECTROMAGNÉTIQUE SUPRACONDUCTRICE, POURVUE D'ENROULEMENTS FORMÉS D'UNE STRUCTURE SUPRACONDUCTRICE PRÉSENTANT DES PIÈCES DE BANDE FORMANT UNE CHAÎNE

(30) Priorität: 04.10.2013 DE 102013220141
(43) Veröffentlichungstag der Anmeldung: 19.08.2015
(73) Patentinhaber: Bruker BioSpin GmbH, 76287 Rheinstetten (DE)
(72) Erfinder: ROTH, Gerhard, 76287 Rheinstetten (DE); KASTEN, Arne, 76139 Karlsruhe (DE); SCHLENGA, Klaus, 76149 Karlsruhe (DE); USOSKIN, Alexander, 63456 Hanau (DE)
(74) Vertreter: Kohler Schmid Möbus Patentanwälte
(86) Internationale Anmeldenummer: PCT/EP2014/071207
(87) Internationale Veröffentlichungsnummer: WO 2015/049357

(56) Entgegenhaltungen:
- EP-A1- 0 413 573
- EP-A2- 2 717 341
- DE-A1- 10 202 372
- US-A- 6 121 205
- US-A1- 2003 213 611
- US-A1- 2005 173 679
- Anonymous: "YBCO Coated Conductors", Online , Juli 2013 (2013-07), XP002734656, Gefunden im Internet: URL:http://www.bruker.com/products/superco nductors-and-metal-composite-materials/sup erconductors/ybco-2g-hts-superconductors/l earn-more.html [gefunden am 2015-01-19]

## Beschreibung

Die Erfindung betrifft ein NMR-Spektrometer mit einer NMR-Magnetspule, die zumindest in einer Sektion Wicklungen umfasst mit einem Leiter aus einer Supraleiterstruktur, umfassend mehrere Bandstücke von bandförmigem Supraleiter, wobei jedes Bandstück ein Substrat und eine darauf abgeschiedene supraleitende Schicht aufweist, und wobei die Bandstücke miteinander verbunden sind.

Supraleiter können elektrische Ströme praktisch ohne ohmsche Verluste tragen. Sie werden insbesondere dort, wo hohe elektrische Stromstärken benötigt werden, eingesetzt, so auch in Magnetspulen.

Supraleiter können den elektrischen Strom bis zu einer kritischen Stromdichte nur unterhalb einer kritischen Temperatur (auch Sprungtemperatur genannt) und unterhalb einer temperatur- und ggf. auch richtungsabhängigen kritischen Magnetfeldstärke verlustfrei übertragen. Oberhalb dieser voneinander abhängigen kritischen Stromdichte, kritischen Temperatur und kritischen Magnetfeldstärke geht der Supraleiter in einen normalleitenden Zustand über.

Als Drähte verarbeitbare, metallische Supraleitermaterialien, wie NbTi, haben relativ niedrige Sprungtemperaturen, NbTi etwa um 9K, so dass ihr Einsatz, insbesondere in Bezug auf die erforderliche Kühlung, recht teuer ist. Desweiteren haben metallische Supraleiter auch relativ niedrige kritische Magnetfelder oberhalb derer sie ihre supraleitende Eigenschaft verlieren.

Hochtemperatursupraleiter (HTSL), wie Yttrium Barium Kupferoxid (YBCO), haben deutlich höhere Sprungtemperaturen, YBCO etwa um 90K, sind aber aufgrund ihrer keramischen Eigenschaften schwer zu verarbeiten. Werden sie bei Temperaturen deutlich unterhalb ihre Sprungtemperatur eingesetzt, können HTSL vergleichsweise große Stromstärken übertragen, d.h. sie weisen eine hohe kritische Stromdichte auf. Mit ihren vergleichsweise hohen kritischen Magnetfeldstärken eignen sich diese Materialien desweiteren auch bei tiefen Betriebstemperaturen zum Einsatz in starken Magnetfeldern, wie sie beispielsweise in NMR-Spektrometern erwünscht sind, um eine hohe spektrale Auflösung zu erreichen.

Üblicherweise werden für technische Anwendungen HTSL auf flexiblen, bandförmigen, meist metallischen Substraten als eine dünne Schicht abgeschieden, wobei in der Regel eine oder mehrere Pufferschichten zwischen dem Substrat und der supraleitenden Schicht vermittelt und eine oder mehrere metallische Abschlussschichten über der supraleitenden Schicht abgeschieden werden. Diese Bauform wird auch als bandförmiger Supraleiter bezeichnet; im Englischen hat sich dafür das Schlagwort "coated conductor" (beschichteter Leiter) etabliert.

Die Abscheidung von supraleitenden Schichten guter Qualität ist jedoch relativ schwierig. In der Regel sind besonders texturierte Substratoberflächen erforderlich, die nur über begrenzte Längen zur Verfügung gestellt werden können. Derzeit sind qualitativ gute Bandstücke von bandförmigen Supraleitern auf einen Bereich von maximal ca. 100 bis 500 m begrenzt. Dadurch wird wiederum die Größe von wickelbaren Spulensektionen in Magnetspulen, etwa von NMR-Spektrometern, begrenzt. Eine Verbindung von Bandstücken mit Joints in einer Magnetspule ist technisch schwierig und erhöht grundsätzlich die Drift der Magnetspule, was vor allem in der hochauflösenden NMR-Spektroskopie unerwünscht ist.

In der EP 0 545 608 A2 wurde vorgeschlagen, Leiterstücken, die nur in begrenzter Länge in guter Qualität gefertigt werden können, aneinander zu fügen, um einen supraleitenden Strom auch über längere Strecken, etwa einige Kilometer, transportieren zu können.

Aus der US 2005/0173679 A1 ist es bekannt geworden, zwei Bandstücken von bandförmigen Supraleiter miteinander zu verbinden, wobei die supraleitenden Schichten auf den jeweiligen Substraten einander zugewandt sind. Die supraleitenden Schichten sollen in supraleitendem Kontakt stehen, und durch die Nähe der beiden polykristallinen supraleitenden Schichten soll die effektive Korngrenzfläche erhöht und damit der kritische Strom verbessert werden.

Aus der US 6,828,507 B1 ist es ebenfalls bekannt geworden, zwei Bandstücke von bandförmigen Supraleiter miteinander zu verbinden, wobei die supraleitenden Schichten auf den jeweiligen Substraten einander zugewandt sind. Die supraleitenden Schichten werden über eine oder mehrere normalleitende Zwischenschichten (etwa Deckschichten der einzelnen Bandstücke) verbunden.

Aus der US 6,121,205 sind Supraleiterstrukturen aus mehreren, überlappend verbundenen Supraleitereinheiten bekannt geworden, wobei die Supraleitereinheiten jeweils ein Substrat aus einem Metalloxidkristall, etwa aus ZrO2 oder MgO, und eine supraleitende Schicht, etwa aus ReBCO-Material, aufweisen. In den Supraleiterstrukturen sind die supraleitenden Schichten der Supraleitereinheiten einander zugewandt.

Die US 2003/0213611 A1 beschreibt eine Supraleiterstruktur aus mehreren, überlappend verbundenen, barrenförmigen Supraleiterstücken aus YBCO-Vollmaterial. Die barrenförmigen Supraleiterstücke können insbesondere in drei übereinander liegenden Ebenen angeordnet und in einer geraden Richtung verbunden werden. In einer beschriebenen Ausführungsform bildet das Supraleitermaterial eine dünne Schicht auf einem einkristallinen MgO-Substrat. Die DE 600 31 784 T2 beschreibt eine Anordnung von zwei HTS-beschichteten Elementen, die mit einander zugewandten HTS-Schichten über metallische Abdeckschichten miteinander verbunden sind. Die HTS-beschichteten Elemente können quer zur Längserstreckungsrichtung geringfügig gegeneinander versetzt angeordnet werden.

Aus der EP 0 413 573 A1 ist eine Spule, gewickelt aus einem supraleitenden Band, bekannt geworden. Das Band umfasst eine supraleitende Folie, die zwischen einer ersten und einer zweiten Folie aus leitfähigem Material wie Kupfer angeordnet ist. Das Band ist helixartig in Lagen gewickelt, wobei zwischen den Lagen und elektrisch isoliert von diesen ein Streifen elektrisch leitfähiger Folie angeordnet ist, dessen Enden miteinander verbunden sind. Die Spule ist mit einem Epoxitharz getränkt.

Die DE 102 02 372 A1, die als nächstkommender Stand der Technik angesehen werden kann, beschreibt ein NMR-Hochfeld-Magnetspulensystem für eine NMR-Messeinrichtung, mit radial ineinander geschachtelten, solenoidförmigen Magnetspulensektionen, wobei eine radial innerste Sektion mit einem bandförmigen Supraleiter gewickelt ist. Der bandförmige Supraleiter kann insbesondere Hochtemperatur-Supraleitermaterial enthalten.

### Aufgabe der Erfindung

Der Erfindung liegt die Aufgabe zugrunde, ein verbessertes NMR-Spektrometer bereitzustellen, insbesondere wobei eine Magnetspule des Spektrometers besonders hohe Magnetfeldstärken in einem Probenvolumen erzeugen kann und driftarm ist. Im Besonderen soll ein NMR-Spektrometer bereitgestellt werden, wobei die Magnetspule eine hohe Stromtragfähigkeit bei hohen Magnetfeldstärken aufweist und im Betrieb über einen Schalter kurzschließbar und zur Erzeugung eines homogenen, zeitlich extrem stabilen Magnetfelds in einem Untersuchungsvolumen im Inneren der Magnetspule geeignet ist, d.h. dass im Kurzschlussbetrieb eine durch Restwiderstände der Leiter der Magnetspule, der Verbindungen zwischen deren Sektionen und/oder des Schalters verursachte Drift des erzeugten Magnetfelds innerhalb tolerabler Grenzen, z.B. für die hochauflösende NMR-Spektroskopie, bleibt.

### Kurze Beschreibung der Erfindung

Diese Aufgabe wird gelöst durch ein NMR-Spektrometer mit einer NMR - Magnetspule, die zumindest in einer Sektion Wicklungen umfasst mit einem Leiter aus einer Supraleiterstruktur, umfassend mehrere Bandstücke von bandförmigem Supraleiter,
wobei jedes Bandstück ein flexibles Substrat und eine darauf abgeschiedene supraleitende Schicht aufweist, wobei die Bandstücke jeweils eine Länge von 20 m oder mehr aufweisen,
und wobei die Bandstücke miteinander verbunden sind,
wobei mindestens eines der Bandstücke als ein verkettetes Bandstück ausgebildet ist,
und wobei ein jedes verkettete Bandstück jeweils mit wenigstens zwei weiteren Bandstücken derart verbunden ist, dass die weiteren Bandstücke zusammen mit wenigstens 95% der gesamten Länge des verketteten Bandstücks überlappen, so dass elektrischer Strom zwischen dem verketteten Bandstück und den gegenüberliegenden, parallelen, weiteren Bandstücken ausgetauscht werden kann, wobei das verkettete Bandstück in einem longitudinalen Bereich um einen Spalt zwischen zwei weiteren Bandstücken, die mit diesem verketteten Bandstück überlappend verbunden sind, fehlerfrei ist. Bei den Bandstücken kann es sich um kommerziell erhältliche Supraleiterbänder, wie oben beschrieben, handeln.

Die Supraleiterstruktur in wenigstens einer Sektion der Magnetspule des erfindungsgemäßen NMR-Spektrometers basiert auf ein oder mehreren verketteten Bandstücken. Im Bereich der Verkettungen weist die Supraleiterstruktur eine besonders hohe Stromtragfähigkeit auf, die vereinzelt auftretende Inhomogenitäten der kritischen Stromdichte und einen damit verbundenen, lokal auftretenden (immer noch sehr kleinen) ohmschen Widerstand beim Betriebsstrom der Magnetspule (der in aller Regel deutlich unter dem kritischen Strom liegt) tolerieren kann. Elektrischer Strom kann zwischen den verbundenen, einander gegenüberliegenden, parallelen Bandstücken ausgetauscht werden. Im Falle von Inhomogenitäten der kritischen Stromdichte (etwa normalleitende Fehlerbereiche in einer supraleitenden Schicht) in einem der Bandstücke werden diese durch das jeweils gegenüberliegende Bandstück überbrückt und umgekehrt, so dass es durch solche Inhomogenitäten zu keiner merklichen Beeinträchtigung der Stromtragfähigkeit der Supraleiterstruktur insgesamt kommt. Dies gilt insbesondere auch für die massivste Störung dieser Art, nämlich an Spalten, wo die Bandstücke angestückelt sind. Erfindungsgemäß ist das verkettete Bandstück in einem longitudinalen Bereich um einen Spalt zwischen zwei weiteren Bandstücken, die mit diesem verketteten Bandstück überlappend verbunden sind, fehlerfrei, insbesondere in einem longitudinalen Bereich von wenigstens 10 m zu beiden Seiten des Spalts. Dieser longitudinale Bereich des verketteten Bandstücks wird unten auch als zweiter longitudinaler Bereich bezeichnet. Der longitudinale Bereich erlaubt einen Wechsel des Stroms mit hinreichend geringem ohmschen Querwiderstand.

Weiterhin sind die Kontaktflächen zwischen den gegenüberliegenden Bandstücken sehr groß: Im Rahmen der vorliegenden Erfindung kann in der Regel die gesamte Länge eines verketteten Bandstücks für den transversalen Stromaustausch genutzt werden, wodurch der Kontaktwiderstand (Querwiderstand) sehr klein wird. Insbesondere ist es möglich, als Kontakt zwischen den supraleitenden Schichten eine oder mehrere Schichten aus normalleitendem Material vorzusehen, ohne dass der ohmsche Widerstand dadurch merklich ansteigt. Gleichwohl sollten diese normalleitenden Schichten aus Materialien von guter elektrischer Leitfähigkeit (etwa Edelmetalle oder Kupfer oder Legierungen dieser Metalle) gefertigt sein. Diese Zwischenschichten können den Herstellungsprozess der Supraleiterstruktur vereinfachen und auch als Wärmeleiter und parallele Strompfade zu den supraleitenden Schichten zur Stabilisierung der Supraleitung und als Quenchschutz hilfreich sein. Insbesondere können die parallelen Bandstücke auch durch ein einfaches Verlöten einer jeweiligen Kupferummantelung verbunden werden. In der Regel erstreckt sich die Verlötung entlang der Bandrichtung über mehr als 5m, vorzugsweise mehr als 20m. Jedenfalls umfasst sie in der Sektion mehrere Windungen.

Im Rahmen der Erfindung ist es möglich, auch bei Verkettung einer großen Zahl von Bandstücken hintereinander keine merklichen ohmschen Leitungswiderstände aufzubauen. Dadurch ist die Erfindung auch für Spulen mit großer Windungszahl, etwa im Kilometerbereich, gut geeignet. Für NMR-Zwecke ist ein sich ergebender Gesamtquerwiderstand von unter einigen 10 nOhm wünschenswert und eine Größenordnung mehr wohl gerade noch akzeptabel. Die Verlötung zweier Bandstücke über die Kupferumhüllung ergab für typische kommerziell erhältliche HTS-Bandleiter einen Querwiderstand von etwa 40 nOhm/cm².

Die Verbindung zweier Bandstücke mit einander zugewandten (gegenüberliegenden) supraleitenden Schichten kann auch im Rahmen der Erfindung einen supraleitenden oder quasi-supraleitenden elektrischen Kontakt bewirken, so dass insgesamt ein verschwindender ohmscher Widerstand auftritt. Wenn sich eine Kupferummantelung des Bandleiters um das Substrat herum erstreckt, können die Bänder auch gestapelt verlötet werden, d.h. die supraleitenden Schichten müssen einander nicht (gespiegelt) zugewandt sein. Das erlaubt es, (bei erhöhtem Querwiderstand) die Substratschicht des Einzelbandes konsequent radial außen zu halten, was das Risiko für ein Ablösen der supraleitenden Schicht durch Lorentz-Kräfte reduziert.

Ein Bandstück wird als verkettetes Bandstück bezeichnet, wenn es mit wenigstens zwei weiteren Bandstücken verbunden ist, die (in Erstreckungsrichtung des Bandstücks / longitudinaler Richtung) zusammen im Wesentlichen mit der gesamten Länge des Bandstücks überlappen. Dadurch stehen die weiteren Bandstücke als paralleler Strompfad für das verkettete Bandstück zur Verfügung, insbesondere an Fehlerbereichen im verketteten Bandstück. Umgekehrt stellt das verkette Bandstück einen parallelen Strompfad für die weiteren Bandstücke zur Verfügung, insbesondere an Spalten (Stößen) zwischen den weiteren Bandstücken.

Ein oder mehrere (insbesondere auch alle) der weiteren Bandstücke, mit denen ein verkettetes Bandstück gemäß der Erfindung überlappend verbunden ist, können ihrerseits verkettete Bandstücke sein. Dadurch können auf einfache Weise praktisch beliebige Windungslängen mit der erfindungsgemäßen Supraleiterstruktur aufgebaut werden. Ein Bandstück in der Supraleiterstruktur kann weiterhin als weiteres Bandstück bezüglich eines oder mehrerer verketteter Bandstücke dienen.

Zwischen den weiteren Bandstücken, die in longitudinaler Richtung der Supraleiterstruktur aufeinander folgen, ist ein (möglichst schmaler) Spalt (Stoß, Anstückelungsbereich) ausgebildet, der vom verketteten Bandstück überbrückt wird. Die weiteren Bandstücke ragen weiterhin in der Regel in longitudinaler Richtung jeweils an einer Seite über das verkettete Bandstück hinaus.

Die NMR-Magnetspule des erfindungsgemäßen NMR-Spektrometers weist in einem ungeschimmten Zustand vorzugsweise in einem Probenvolumen von wenigstens 1 cm³, bevorzugt wenigstens 10 cm³, eine Homogenität von 100 ppm oder besser, bevorzugt 10 ppm oder besser, besonders bevorzugt 2 ppm oder besser auf und erzeugt dort vorzugsweise eine magnetische Flussdichte von 10 Tesla oder mehr, insbesondere von 20 Tesla oder mehr, oder auch 23,5 Tesla oder mehr, beispielsweise 28,2 Tesla (= 1200 MHz Protonenresonanzfrequenz). Die Bandstücke der Supraleiterstruktur weisen jeweils ein flexibles, bevorzugt metallisches Substrat auf, etwa aus Stahl, das aufgewickelt werden kann, insbesondere um eine Sektion der NMR-Magnetspule zu wickeln. Typische Breiten der Bandstücke liegen im Bereich 2 mm bis 60 mm. Typische Dicken der Bandstücke liegen im Bereich 25 µm bis 300 µm. Die Längen der Bandstücke liegen bei 20 m oder länger, meist 100 m oder länger.

### Bevorzugte Ausführungsformen der Erfindung

Bei einer bevorzugten Ausführungsform des erfindungsgemäßen NMR-Spektrometers umfasst die Supraleiterstruktur wenigstens N verkettete Bandstücke, mit N ≥ 5, bevorzugt N ≥ 20, insbesondere wobei die N verketteten Bandstücke aufeinanderfolgend miteinander verbunden sind, derart, dass zumindest eines der weiteren Bandstücke eines jeden der verketteten Bandstücke seinerseits ein verkettetes Bandstück ist. Dadurch kann die Supraleiterstruktur unter Nutzung ihrer Vorteile auf beliebigen, insbesondere auch großen Längen genutzt werden. Für alle (bezüglich der Bandrichtung) inneren Bandstücke einer Abfolge von aufeinanderfolgend miteinander verbundenen, verketteten Bandstücken sind zwei weitere Bandstücke jeweils verkettete Bandstücke, und für die beiden äußeren Bandstücke der Abfolge ist lediglich eines der weiteren Bandstücke ein verkettetes Bandstück. Die Supraleiterstruktur dieser Variante umfasst grundsätzlich parallele Bandstücke in mindestens zwei Ebenen (obere und untere Ebene). Die verketteten Bandstücke in der oberen Ebene sind hintereinander angeordnet und vorzugsweise mit ihren supraleitenden Schichten nach unten orientiert, und die verketteten Bandstücke in der unteren Ebene sind ebenfalls hintereinander angeordnet und vorzugsweise mit ihren supraleitenden Schichten nach oben orientiert.

Bei einer bevorzugten Weiterbildung dieser Ausführungsformen ist die Supraleiterstruktur über die verketteten Bandstücke in Erstreckungsrichtung der verketteten Bandstücke periodisch ausgebildet. Dies macht den Aufbau besonders einfach; insbesondere können Bandstücke gleicher Länge verbaut werden.

Eine bevorzugte Ausführungsform sieht vor, dass in wenigstens einem verketteten Bandstück wenigstens ein bekannter Fehlerbereich vorhanden ist, und dass wenigstens eines der weiteren Bandstücke, das mit diesem verketteten Bandstück überlappt, so ausgewählt und/oder in longitudinaler Richtung positioniert ist, dass das weitere Bandstück in einem weiteren longitudinalen Bereich um den bekannten Fehlerbereich fehlerfrei ist, insbesondere in einem weiteren longitudinalen Bereich von wenigstens 10 m zu beiden Seiten des bekannten Fehlerbereichs. Der weitere longitudinale Bereich des weiteren Bandstücks wird unten auch als erster longitudinaler Bereich bezeichnet. Für den Fall bekannter (und akzeptierter) Fehlerbereiche in einem Bandstück sollte dieses mit einem überlappenden Bandstück verbunden werden, das so ausgewählt und ggf. longitudinal verschoben ist, dass dieses überlappende Bandstück jeweils in einem longitudinalen Bereich um die bekannte Fehlerstelle des ersten Bandstücks fehlerfrei ist, in der Regel in einem Bereich von etwa 10 m bis zu einigen zig Metern. Dies erlaubt noch einen Wechsel des Stroms mit hinreichend geringem ohmschen Querwiderstand.

Bei einer vorteilhaften Ausführungsform ist vorgesehen, dass die Sektion Wicklungen in mehreren radialen Wickellagen umfasst, und dass Spalte zwischen zwei weiteren Bandstücken, die mit demselben verketteten Bandstück überlappend verbunden sind, in radial übereinander liegenden Wickellagen azimutal voneinander beabstandet sind. Da Anstückelstellen (Spalte) auch potenzielle mechanische Schwachstellen sind, sollten sie bei mehrlagigen Wicklungen nicht radial übereinander oder longitudinal nebeneinander liegen.

Dadurch kann die mechanische Stabilität der Magnetspule erhöht werden. Insofern sollte bevorzugt, wo möglich, bereits bei der Herstellung des Leiters mit einer Struktur aus verketteten Bandstücken darauf geachtet werden, wo kritische Leiterstücke später in der Spulensektion liegen werden. Bestimmte vorhandene Bandstücke können daraufhin gezielt gekürzt und verbunden werden um z.B. die o.g. Kriterien einzuhalten.

Vorteilhaft ist es entsprechend weiterhin, wenn vorgesehen ist, dass die Sektion mehrere axial benachbarte Wicklungen in wenigstens einer Wickellage umfasst, und dass Spalte in derselben Wickellage azimutal voneinander beabstandet sind.

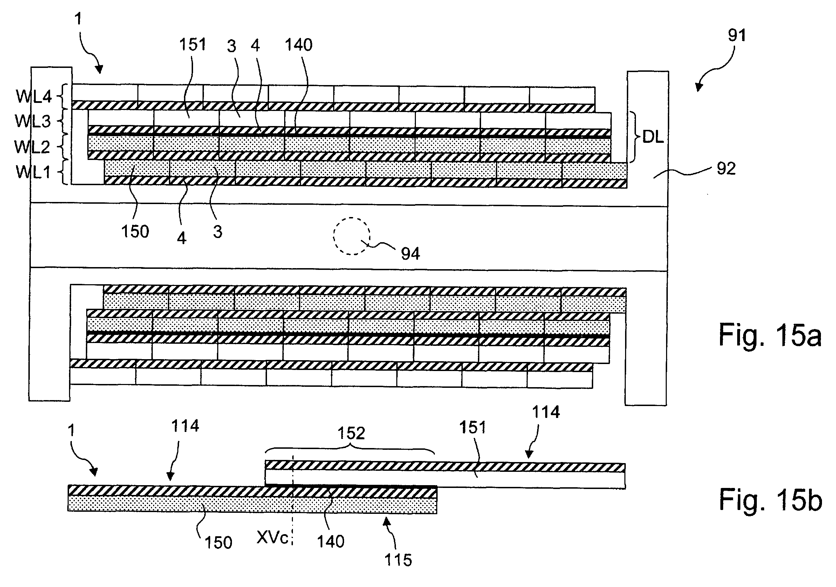

Bei einer vorteilhaften Ausführungsform des erfindungsgemäßen NMR-Spektrometers ist vorgesehen, dass die Sektion zumindest eine Einfach-Band-Teilsektion aufweist, die mit einem einfachen, ununterbrochenen Bandstück gewickelt ist, und zumindest eine Mehrfach-Band-Teilsektion aufweist, die mit einem Leiter aus der Supraleiterstruktur gewickelt ist. Stehen große Längen eines fehlerfreien Bandleiters zur Verfügung, die aber nicht ausreichen, die gesamte gewünschte Spulensektion durchgehend zu wickeln, können Einfachband-Teilsektionen gebildet werden, die nur aus einem durchgehenden Bandleiter (Bandstück) gewickelt sind (mit voller Stromdichte), und weiter Mehrfachband-Teilsektionen mit verketteten Bandstücken (mit reduzierter Stromdichte). Die geometrische Anordnung dieser Teilsektionen kann zur Feldhomogenisierung mit ausgenutzt werden. Eine mögliche Anordnung in einer Magnetspule wären eine axial innere Teilsektion mit Verkettung, axial umgeben von zwei Teilsektionen mit durchgehendem Bandleiter. Es kann jedoch z.B. auch wickel-lagenweise von einem Einfachband auf ein angestückeltes Doppelband (und ggf. zurück) gewechselt werden. Im Extremfall dient dann ein eine Lage in einem Doppelband mit einer Anstückelung des Einfachbandes als (quasi-)supraleitende Verbindung (joint) innerhalb einer Sektion. Dies kann vorteilhaft auf zwei Arten geschehen. In der ersten Variante steigt das Einfachband an einem axialen Ende der Sektion in die radial übernächste Wickellage. In der dazwischenliegenden nächsten Wickellage liegt ein ab dem Sektionsende zugewickeltes, weiteres Bandstück, das die Sektion bis zum anderen axialen Ende abdeckt. Das ursprüngliche Bandstück und das zugewickelte Bandstück sind bis etwa zur axialen Mitte der Sektion zu einem Doppelband verlötet. Dort endet (in der übernächsten Lage) das ursprüngliche Bandstück und ein neues Bandstück wird angestückelt und mit dem zugewickelten Bandstück (bis zum axialen Ende der Sektion) verlötet. Dadurch wird der Spulenstrom über die erste axiale Hälfte der Sektion vom ursprünglichen Bandstück in das zugewickelte Bandstück transferiert und in der zweiten Hälfte vom zugewickelten Bandstück in das angestückelte Bandstück. Bevorzugt sind die supraleitenden Schichten der verlöteten Bandstücke hierbei einander zugewandt. In einer zweiten Variante (vgl. dazu Anspruch 29 und Fig. 15a, 15b) wird in mindestens einer Doppellage, die sich von einem axialen Ende der Sektion bis zum anderen Ende erstreckt, der Spulenstrom von einem ankommenden Bandstück in einer Lage auf ein angelötetes Bandstück in der nächsten Lage transferiert. Dafür steht die gesamte axiale Länge der Sektion zur Verfügung; im Falle einer Verlötung über mehrere Doppellagen steht die axiale Länge der Sektion entsprechend mehrfach zur Verfügung, was den Übergangswiderstand weiter absenkt. In dieser zweiten Variante erscheint es vorteilhafter, die verlöteten Bandstücke einfach zu stapeln, um das Substrat radial außen zu halten; in dem Fall, dass die Bandstücke jeweils vollständig mit einem elektrisch hochleitfähigen Material, bevorzugt Kupfer, ummantelt sind (z.B. dadurch, dass eine Kupferfolie den gesamten bandförmigen Supraleiter umgibt und auf einer Seite, bevorzugt der Substratseite, auf Stoß zusammengelötet ist), bleibt in Verbindung mit der großen Transferlänge für den Stromübergang zwischen den verlöteten Bandstücken der ohm'sche Querwiderstand in einem akzeptablen Rahmen. In ersten Testversuchen ergaben sich Übergangswiderstände deutlich kleiner als 1 nOhm.

Bevorzugt ist eine Weiterbildung der obigen Ausführungsform, bei der die Sektion zwei axial äußere Einfach-Band-Teilsektionen aufweist, und eine axial mittlere Mehrfach-Band-Teilsektion, insbesondere wobei die axial mittlere Mehrfach-Band-Teilsektion lediglich ein verkettetes Bandstück aufweist. Die axial mittlere Mehrfach-Band-Teilsektion, in der die Stromdichte gegenüber einer Einfach-Band-Teilsektion reduziert ist, befindet sich dann im zentralen Bereich der Magnetspule, wo besonders hohe Magnetfeldstärken auftreten.

Besonders bevorzugt ist eine Ausführungsform, bei der das verkettete Bandstück einerseits und die weiteren Bandstücke andererseits mit einander zugewandten supraleitenden Schichten miteinander überlappend verbunden sind. Dadurch kann der elektrische Widerstand zwischen dem verketteten Bandstück und seinen zugehörigen weiteren Bandstücken besonders gering gehalten werden. In einer alternativen Ausführungsform, die bezüglich in der Spulensektion auftretender radialer Kräfte vorteilhaft sein kann, sind die supraleitenden Schichten in den Bandstücken in beiden Ebenen der Supraleiterstruktur (also im verketteten Bandstück einerseits und dessen zugehörigen weiteren Bandstücken andererseits) zur gleichen Seite hin orientiert; typischerweise ist dabei in einer gewickelten Magnetspule für alle Bandstücke das Substrat (meist ein Stahlblech) radial nach außen und die supraleitende Schicht radial nach innen orientiert. In diesem Fall wird der transversale Stromtransport in der Regel zumindest teilweise über verlötete Kupferummantelungen der Bandstücke laufen.

Bevorzugt ist auch eine Ausführungsform, bei der die Supraleiterstruktur wenigstens zwei randseitige Bandstücke aufweist, wobei ein randseitiges Bandstück jeweils mit einem verketteten Bandstück derart verbunden ist, dass das verkettete Bandstück im Wesentlichen mit der gesamten Länge des randseitigen Bandstücks überlappt. Mit den randseitigen Bandstücken kann die Supraleiterstruktur an ihren beiden Enden abgeschlossen werden und die Wicklungseingänge bzw. Ausgänge der Sektion/Teilsektion bilden. Die randseitigen Bandstücke können in derselben Ebene oder auch in verschiedenen Ebenen angeordnet sein. Typischerweise überlappt das verkettete Bandstück mit wenigstens 95%, bevorzugt wenigstens 99% oder auch 100% der Länge des randständigen Bandstücks.

Bei einer besonders bevorzugten Ausführungsform der erfindungsgemäßen Supraleiterstruktur überlappen die weiteren Bandstücke zusammen mit wenigstens 95%, bevorzugt wenigstens 99% der gesamten Länge des verketteten Bandstücks. Dadurch kann eine sehr große Kontaktfläche zwischen den überlappenden Bandstücken und ein entsprechend geringer elektrischer Widerstand erreicht werden. Eine etwaige verbleibende (nicht-überlappte) Länge des verketteten Bandstücks entfällt typischerweise auf einen Spalt (oder mehrere Spalten) zwischen den weiteren Bandstücken, und/oder auf Ein- oder Ausleitestellen für den elektrischen Strom (dann meist an den Enden einer Sektion oder Teilsektion der Magnetspule).

Bevorzugt ist auch eine Ausführungsform, bei der das verkettete Bandstück eine Länge von wenigstens 100 m, bevorzugt wenigstens 200 m, aufweist. Dies stellt zum einen sicher, dass auch die Überlappungslängen mit den weiteren Bandstücken groß sind (meist ca. die Hälfte der Länge des verketteten Bandstücks je weiterem Bandstück), zum anderen kann mit solch großen Bandstücklängen effizient eine große Gesamtlänge des Leiters der Spulensektion eingerichtet werden.

Ebenfalls bevorzugt ist eine Ausführungsform, bei der die Supraleiterstruktur (bzw. der Leiter einer Sektion/Teilsektion) eine Gesamtlänge von wenigstens 1000 m, bevorzugt wenigstens 2000 m aufweist. Die erfindungsgemäße Struktur kann solche großen Gesamtlängen ohne weiteres bereitstellen; entsprechend können große Magnetspulen mit hoher magnetischer Flussdichte gefertigt werden.

Bei einer vorteilhaften Ausführungsform weist ein Spalt zwischen zwei weiteren Bandstücken, die mit demselben verketteten Bandstück überlappend verbunden sind, eine Spaltbreite in Erstreckungsrichtung der Bandstücke von 5mm oder weniger, bevorzugt 2mm oder weniger auf, insbesondere ist der Spalt bei aneinander anstoßenden weiteren Bandstücken geschlossen ausgebildet. Dadurch wird die Länge, über die nur das verkettete Bandstück, nicht aber die weiteren Bandstücke zur Stromtragung zur Verfügung stehen, minimiert.

Bevorzugt ist auch eine Ausführungsform, bei der ein Spalt zwischen zwei weiteren Bandstücken, die mit demselben verketteten Bandstück überlappend verbunden sind, zumindest näherungsweise mittig bezüglich der Länge dieses verketteten Bandstücks angeordnet ist. Durch die mittige Spaltanordnung steht für die Kontaktflächen zu den weiteren Bandstücken näherungsweise die gleiche Teillänge zur Verfügung, wodurch eine einseitige Erhöhung des Kontaktwiderstands zu einem der weiteren Bandstücke vermieden wird. Typischerweise weicht die Spaltposition maximal 10%, bevorzugt maximal 5%, von der Mitte des verketteten Bandstücks ab, bezogen auf die Länge des verketteten Bandstücks.

Bei einer vorteilhaften Ausführungsform der erfindungsgemäßen Supraleiterstruktur ist vorgesehen, dass die einander gegenüberliegenden Enden von zwei weiteren Bandstücken, die mit demselben verketteten Bandstück überlappend verbunden sind, sich jeweils auf das andere weitere Bandstück zu verjüngen, insbesondere so dass ein Spalt zwischen diesen zwei weiteren Bandstücken zumindest abschnittsweise mit einem Winkel zwischen 5° und 30° zur Erstreckungsrichtung der Bandstücke verläuft. Bei dieser Variante verläuft der Spalt zwischen den weiteren Bandstücken zumindest abschnittsweise schräg (und insbesondere nicht senkrecht) zur Erstreckungsrichtung des verketteten Bandstücks. Der Spalt zieht sich über eine erhebliche Strecke (in Erstreckungsrichtung des verketteten Bandstücks) hin, nimmt aber nirgends die volle Breite des Supraleiterstruktur ein (vgl. typische Bandbreiten von zwischen 2 mm und 6 cm). Diese Bauform hat sich in der Praxis bewährt.

Ebenfalls bevorzugt ist eine Ausführungsform, bei der die supraleitenden Schichten von miteinander überlappend verbundenen Bandstücken
- unmittelbar aneinander grenzen,
- oder durch eine oder mehrere edelmetallhaltige Schichten, insbesondere silberhaltige Schichten, und/oder eine oder mehrere kupferhaltige Schichten, insbesondere Kupferschichten, miteinander verbunden sind. Im Falle eines unmittelbaren Aneinandergrenzens kann grundsätzlich ein sehr guter (sogar supraleitender) Kontakt zwischen den supraleitenden Schichten hergestellt werden; allerdings ist die Jointtechnologie schwierig zu beherrschen. Im Falle einer Verbindung über eine normalleitende Schicht (oder mehrere solche Schichten) ist die Herstellung der Supraleiterstruktur vereinfacht, und die Schichten können funktionell (etwa zur Stabilisierung und als Quenchschutz) eingesetzt werden. Aufgrund der großen Kontaktflächen tritt durch die normalleitende Schicht (oder mehrere solcher Schichten) bei geeigneter Materialwahl (etwa ausreichend guter elektrische Leitfähigkeit) und geeignete Schichtdickenwahl (nicht zu dick) nur ein vernachlässigbarer ohmscher Widerstand auf.

Vorteilhaft ist weiterhin eine Ausführungsform, bei der die Bandstücke der Supraleiterstruktur außenseitig mit einer Shunt-Struktur versehen sind, insbesondere teilweise oder vollständig von einer Shunt-Schicht umhüllt sind. Dadurch wird ein normalleitender Strompfad parallel zu den supraleitenden Schichten zur Verfügung gestellt, über die im Falle eines plötzlichen Zusammenbruchs der Supraleitung ("Quench") der zuvor supraleitend getragene elektrische Strom übernommen werden kann. Dadurch soll eine Überhitzung ("Durchbrennen") der supraleitenden Schichten vermieden werden.

Die Shunt-Struktur kann insbesondere aus Kupfer gefertigt sein.

Bei einer bevorzugten Weiterbildung dieser Ausführungsform ist vorgesehen, dass jeweils zwei Bandstücke, die miteinander überlappend verbunden sind, quer zur Erstreckungsrichtung der Bandstücke in einem oder mehreren Überstandbereichen nicht überlappen,
und dass die Shunt-Struktur in mindestens einem besagten Überstandbereich das zugehörige Bandstück kontaktiert. Dadurch ist die Ausleitung des elektrischen Stroms aus den supraleitenden Schichten der Bandstücke im Quenchfall besonders einfach. Zwei Überstandbereiche können aufgrund eines Versatzes von gleich breiten Bandstücken quer zur Erstreckungsrichtung der Bandstücke entstehen; ein oder zwei Überstandbereiche können durch Verwendung unterschiedlich breiter Bandstücke entstehen.

Besonders bevorzugt ist auch eine Ausführungsform, bei der die supraleitende Schicht ein Hochtemperatur-Supraleitermaterial, insbesondere vom YBCO- oder BSCCO-Typ, enthält. Mit HTSL-Material können besonders hohe Stromtragfähigkeiten (bei tieferen Temperaturen, etwa mit LHe-Kühlung) erreicht werden. Als HTSL-Materialien im Rahmen der Erfindung gelten alle Materialien mit einer Sprungtemperatur oberhalb von 40K. BSCCO-Materialien können Bi₂Sr₂CaCu₂O₈₊ₓ und/oder Bi₂Sr₂Ca₂Cu₃O₁₀₊ₓ umfassen.

Vorteilhaft ist eine Weiterbildung dieser Ausführungsform, bei der wenigstens eines der weiteren Bandstücke ein Joint zu einem

Tieftemperatursupraleiter(=LTS)-Draht, enthaltend Filamente eines LTS-Supraleitermaterials, ausbildet, wobei dieses weitere Bandstück und der LTS-Draht über wenigstens 1 m, bevorzugt wenigstens 10 m, in Längsrichtung des weiteren Bandstücks überlappen und mittels eines Lots miteinander verlötet sind. Dadurch kann ein niederohmiger Übergang zum LTS-Draht eingerichtet werden. Das Joint sollte außerhalb des Hochfelds angeordnet werden, um eine gute Stromtragfähigkeit zu erreichen. Typischerweise wird als LTS-Material NbTi eingesetzt. Bevorzugt wird an jedem Ende der Supraleiterstruktur ein solcher Joint vorgesehen. Die Filamente und/oder die supraleitende Schicht können im Bereich des Joints von Umhüllungen oder Schutzschichten befreit werden. Als LTS-Materialien im Rahmen der Erfindung gelten alle Materialien mit einer Sprungtemperatur unterhalb von 40K, insbesondere NbTi und Nb3Sn.

Bevorzugt ist auch eine Weiterbildung, die vorsieht, dass die Magnetspule wenigstens eine HTS-Sektion, die Wicklungen mit einem Leiter aus der Supraleiterstruktur umfasst, und wenigstens eine LTS-Sektion, die Wicklungen aus einem LTS-Draht umfasst, aufweist, insbesondere wobei die HTS-Sektion und die LTS-Sektion ineinander geschachtelt mit der HTS-Sektion innen liegend angeordnet sind. Dadurch kann ein Spulenaufbau geeignet für besonders hohe Magnetfeldstärken realisiert werden. Die HTS-Sektionen und die LTS-Sektionen, die in Serie miteinander verschaltet sind, werden bevorzugt supraleitend kurzgeschlossen im "persistent mode" betrieben; bekannte Maßnahmen gegen eine Restdrift können in üblicher Weise angewandt werden.

Ebenfalls vorteilhaft ist eine Ausführungsform, bei der zwischen Substrat und supraleitender Schicht eine Pufferschicht, insbesondere enthaltend CeO2, angeordnet ist. Dadurch kann die Qualität der supraleitenden Schicht verbessert werden. Gegebenenfalls können auch mehrere Pufferschichten eingesetzt werden.

### Ausführungsformen mit drei oder mehr Bandlagen

Bevorzugt ist auch eine Ausführungsform des erfindungsgemäßen NMR-Spektrometers, bei der die Supraleiterstruktur zumindest in einem Abschnitt einen M-fach-Band-Aufbau aufweist, mit M aus IN und M≥3, in welchem mindestens eines der Bandstücke als ein mehrfach verkettetes Bandstück ausgebildet ist, wobei ein jedes mehrfach verkettete Bandstück jeweils mit M-1 Sets von jeweils wenigstens zwei weiteren Bandstücken (7a-7e) derart verbunden ist, dass die weiteren Bandstücke (7a-7e) eines jeden Sets zusammen mit wenigstens 95% der gesamten Länge (L) des mehrfach verketteten Bandstücks (2a) überlappen. Durch mehrere Sets von weiteren Bandstücken kann die an jeder Stelle eines mehrfach verketteten Bandstücks bzw. einer auf mehrfach verketteten Bandstücken basierenden Supraleiterstruktur die Anzahl an fehler- oder spaltüberbrückenden Strompfaden gesteigert werden; dadurch kann die nutzbare Stromdichte in den Bandstücken der Supraleiterstruktur erhöht werden.

Eine Sektion aus Doppelband (2-Fach-Band) kann nahezu verlustfrei nur etwa denselben Strom tragen wie eine Sektion aus einem (nicht angestückelten) fehlerfreien Einzelband, da an einem Stoß im Doppelband ein überbrückendes Bandstück allein den gesamten Stromfluss tragen muss. Damit ist die nutzbare Stromdichte in einem Doppelband gegenüber einem Einzelband effektiv etwa halbiert. Abhängig von den verfügbaren Längen, deren Fehlerfreiheit und dem auftretenden Querwiderstand pro Länge, kann es sinnvoll sein, Abfolgen (Stapel) von mehr als zwei Bandlagen (Ebenen) zu verbinden und zu verketten, z.B. drei. Dadurch sinkt zwar der Abstand zwischen den Anstückelungen (Spalten, Stößen); allerdings können dann bei M Lagen an jeder Stelle M-1 longitudinale, durchgehende Strompfade genutzt werden. Bei M=3 Lagen ist in der supraleitenden Struktur (nahezu) eine Verdopplung des Stroms des Einzelbandes oder Doppelbands möglich, da an einem Stoß zwei Strompfade bzw. überbrückende Bandstücke zur Verfügung stehen, d.h. die effektive Stromdichte kann im 3-Fach-Band wieder etwas größer sein (mit ca. 2/3 der kritischen Stromdichte bezüglich eines Einzelbands) als beim Doppelband (mit ca. 1/2 der kritischen Stromdichte bezüglich eines Einzelbands).

Die effektive Stromdichte kann durch noch mehr Lagen (größere M) weiter gesteigert werden. Allerdings werden mit steigendem M die Produktion des Leiters und der Wickelvorgang schwieriger, teurer und fehleranfälliger, so däss in den meisten Fällen das Doppelband oder das 3-Fach-Band die beste Wahl ist.

Bei einem M-fach-Band-Aufbau ist grundsätzlich für das mehrfach verkettete Bandstück und jedes Set jeweils eine Ebene (Bandlage) in der Supraleiterstruktur eingerichtet, entsprechend M übereinander liegenden Ebenen (Bandlagen) insgesamt. Typischerweise umfasst eine Supraleiterstruktur 5 oder mehr, bevorzugt 20 oder mehr mehrfach verkettete Bandstücke; diese sind meist aufeinanderfolgend miteinander verbunden, derart, dass zumindest eines der weiteren Bandstücke in jedem Set eines mehrfach verketteten Bandstücks seinerseits ein mehrfach verkettetes Bandstück ist.

Man beachte, dass im Rahmen der Erfindung die Magnetspule im Allgemeinen mehrere in Serie geschaltete Sektionen oder Teilsektionen enthält, die entweder mit einem einfachen Bandleiter gewickelt sind und/oder aus einem Doppelband mit der oben beschriebenen Verkettung der einzelnen verbundenen Bandstücke gewickelt sind und/oder aus einem M-fach-Band mit M>2 gewickelt sind, wobei jedoch mindesten eine Sektion oder Teilsektion mit einem Mehrfachband gewickelt ist. Die in den vorangehenden Absätzen aufgeführten vorteilhaften Weiterbildungen für Doppelbänder sind auch auf M-fach-Bänder übertragbar.

Vorteilhaft ist eine Weiterbildung dieser Ausführungsform, bei der die Spalte zwischen zwei weiteren Bandstücken verschiedener Sets, die mit demselben mehrfach verketteten Bandstück überlappen, näherungsweise gleichmäßig über die Länge des mehrfach verketteten Bandstücks verteilt angeordnet sind. Dadurch wird zum einen vermieden, dass Spalte verschiedener Sets übereinander liegen, und zum anderen können die Längen zwischen den Spalten in der supraleitenden Struktur vereinheitlicht werden. Dadurch wird eine optimale Nutzung der Stromtragfähigkeit der verbundenen Bandstücke erreicht.

Eine andere, bevorzugte Weiterbildung sieht vor, dass die Supraleiterstruktur einen 3-fach-Band-Aufbau mit M=3 aufweist, wobei Bandstücke in drei Lagen übereinander angeordnet sind, dass die Bandstücke der beiden außen liegenden Lagen mit ihren supraleitenden Schichten den Bandstücken der mittleren Lage zugewandt sind, und dass die Bandstücke der mittleren Lage mit ihren supraleitenden Schichten den Bandstücken der beiden äußeren Lagen alternierend zugewandt sind. Dadurch kann zumindest abschnittsweise ein niederohmiger Übergang zwischen den beiden äußeren Lagen und der mittleren Lage eingerichtet werden.

Vorteilhafter Weise ist dabei eingerichtet, dass Spalte zwischen den Bandstücken der beiden äußeren Lagen in Längsrichtung gegeneinander versetzt sind, und dass die Bandstücke der mittleren Lage mit ihrer supraleitenden Schicht jeweils derjenigen außen liegenden Lage zugewandt sind, an der über die Länge des jeweiligen Bandstücks der mittleren Lage ein Spalt auftritt. Dadurch steht ein niederohmiger Stromübergang von den Bandstücken der beiden äußeren Lagen zu den Bandstücken der mittleren Lage immer dort zur Verfügung, wo er besonders gebraucht wird, nämlich in der Umgebung der Spalte, wodurch der gesamte Widerstand der Supraleiterstruktur gering gehalten werden kann. Die Bandstücke der mittleren Lage können am einfachsten halb so lang wie die Bandstücke der äußeren Lagen gewählt werden, weiterhin können die Spalte der einen äußeren Lage jeweils mittig zu den Spalten der anderen äußeren Lage angeordnet werden, und weiterhin können die Bandstücke der mittleren Lage jeweils mittig zum jeweils überbrückten Spalt der äußeren Lage angeordnet werden.

### Erfindungsvariante mit Doppellage

In den Rahmen der vorliegenden Erfindung fällt auch ein NMR-Spektrometer mit einer NMR-Magnetspule, die zumindest in einer Sektion solenoidförmig mehrlagig gewickelt ist und Wicklungen umfasst mit einem Leiter aus einer Supraleiterstruktur, umfassend mehrere in Serie geschaltete Bandstücke von bandförmigem Supraleiter, wobei jedes Bandstück ein flexibles, metallisches Substrat und eine darauf abgeschiedene supraleitende Schicht aufweist, und wobei in der Sektion mindestens zwei Bandstücke aneinander gestückelt sind, wobei diese Bandstücke auf einer Bandlänge von mindestens 20 m miteinander normalleitend verlötet sind, wodurch diese Bandstücke elektrisch in Serie geschaltet sind, und wobei diese Bandstücke über die normalleitend verlötete Bandlänge als eine komplette Doppellage oder mehrere komplette Doppellagen gewickelt sind, so dass Übergänge von einem Einfachband zu einem Mehrfachband an axialen Enden der Sektion erfolgen. Bei dieser Bauform sind die beiden Bandstücke über die normalleitend gelötete Bandlänge als mindestens eine Doppellage gewickelt, wobei sich eine Doppellage jeweils über die gesamte axiale Länge der Sektion erstreckt. Mit der Supraleiterstruktur können zwei (oder hintereinander noch mehr) Bandstücke mit geringem elektrischen Widerstand aneinander gestückelt werden, wobei jeweils ein Überlapp der beiden Bandstücke über die normalleitend verlötete Bandlänge eingerichtet ist. Aufgrund der großen Länge der normalleitend verlöteten Bandlänge ist der ohmsche Widerstand beim Übergang des elektrischen Stroms von einen Bandstück zum anderen, in Serie geschalteten Bandstück sehr gering; in der Praxis wurden bereits weniger als 1 nOhm Übergangswiderstand erreicht. An den axialen Enden einer Doppellage geht jeweils eines der beiden Bandstücke in eine Einfachlage (oder ggf. auch beide in eine weitere Doppellage) über, die unter oder über der Doppellage gewickelt ist. Durch den Übergang an den axialen Enden der Doppellage werden Stufen in der Wicklung der Sektion vermieden, was Kraftspitzen durch Lorentz-Kräfte im Betrieb der Magnetspule vermeidet. Man beachte, dass das Verlöten der Bandstücke mit einander zugewandten supraleitenden Schichten erfolgen kann, oder bevorzugt mit radial gleichgerichteten, insbesondere radial nach innen gerichteten, supraleitenden Schichten. Dies bietet Vorteile bezüglich der auf die supraleitenden Schichten wirkenden radialen Lorentz-Kräfte, die durch das radial außen liegende metallische Substrat abgefangen werden. In Verbindung mit einer weiter oben beschriebenen Kupferummantelung der Bandstücke kann der gegenüber der Bauform mit einander zugewandten supraleitenden Schichten erhöhte ohm'sche Übergangswiderstand in tolerablen Grenzen gehalten werden. Im Übrigen können das NMR-Spektrometer und die Supraleiterstruktur, und insbesondere die Bandstücke, entsprechend der zuvor beschriebenen Erfindungsvariante (umfassend mindestens ein verkettetes Bandstück) ausgebildet werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: einen schematischen Längsschnitt durch einen periodischen Teil einer Supraleiterstruktur für die Magnetspule eines erfindungsgemäßen NMR-Spektrometers;
- Fig. 2: einen schematischen Längsschnitt durch eine Supraleiterstruktur für die Magnetspule eines erfindungsgemäßen NMR-Spektrometers, mit fünf verketteten Bandstücken und zwei randständigen Bandstücken;
- Fig. 3a: eine schematische Schrägansicht auf einen Teil einer Supraleiterstruktur für die Magnetspule eines erfindungsgemäßen NMR-Spektrometers, im Bereich eines quer zur Erstreckungsrichtung verlaufenden Spalts;
- Fig. 3b: eine schematische Schrägansicht auf einen Teil einer Supraleiterstruktur für die Magnetspule eines erfindungsgemäßen NMR-Spektrometers, im Bereich eines schräg zur Erstreckungsrichtung verlaufenden Spalts;
- Fig. 4a-4f: schematische Querschnitte durch verschiedene Ausführungsformen einer Supraleiterstruktur für die Magnetspule eines erfindungsgemäßen NMR-Spektrometers;
- Fig. 5: ein Diagramm schematisch darstellend den transversalen Strom durch ein verkettetes Bandstück einer Supraleiterstruktur als Funktion des Orts entlang der Erstreckungsrichtung der Supraleiterstruktur, gemäß der Erfindung;
- Fig. 6: einen schematischen Längsschnitt durch eine Supraleiterstruktur für die Magnetspule eines erfindungsgemäßen NMR-Spektrometers, mit Bandstücken unterschiedlicher Länge;
- Fig. 7a: einen schematischen Längsschnitt durch eine Supraleiterstruktur für die Magnetspule eines erfindungsgemäßen NMR-Spektrometers, mit 3-fach-Band-Aufbau, mit gleichmäßig verteilten Spalten;
- Fig. 7b: einen Querschnitt durch die Supraleiterstruktur von Fig. 7a bei Ebene Vllb;
- Fig. 8: einen schematischen Längsschnitt durch eine Supraleiterstruktur für die Magnetspule eines erfindungsgemäßen NMR-Spektrometers, mit 3-fach-Band-Aufbau, mit alternierend orientierten supraleitenden Schichten der Bandstücke in der mittleren Lage;
- Fig. 9: eine schematische Längsschnittansicht einer NMR-Magnetspule für ein erfindungsgemäßes NMR-Spektrometer, gewickelt mit einer Supraleiterstruktur, die als Doppelband aufgebaut ist;
- Fig. 10: eine schematische Querschnittsansicht einer NMR-Magnetspule für ein erfindungsgemäßes NMR-Spektrometer, mit azimutal verteilten Spalten;
- Fig. 11a: eine schematische Längsschnittansicht einer NMR-Magnetspule für ein erfindungsgemäßes NMR-Spektrometer, gewickelt mit einer Supraleiterstruktur, die zwei Einfachband-Teilsektionen und eine Doppelband-Teilsektion aufweist;
- Fig. 11b: einen schematischen Längsschnitt durch die abgewickelte Supraleiterstruktur der Magnetspule von Fig. 11 a;
- Fig. 12a: einen schematischen Längsschnitt durch eine NMR-Magnetspule für ein erfindungsgemäßes NMR-Spektrometer, mit einer HTS-Sektion und einer LTS-Sektion;
- Fig. 12b: einen schematischen Querschnitt durch den Überlappbereich eines weiteren Bandstücks und eines LTS-Drahts der Magnetspule von Fig. 12a im Bereich der dortigen Schnittebene Xllb;
- Fig. 13: eine Schemadarstellung eines erfindungsgemäßen NMR-Spektrometers;
- Fig. 14a: eine schematische Längsschnittansicht einer NMR-Magnetspule für ein erfindungsgemäßes NMR-Spektrometer, gewickelt mit einem verketteten Bandstück in einer Doppellage;
- Fig. 14b: einen schematischen Längsschnitt durch die abgewickelte Supraleiterstruktur der Magnetspule von Fig. 14a;
- Fig. 15a: eine schematische Längsschnittansicht einer NMR-Magnetspule für ein erfindungsgemäßes NMR-Spektrometer, gewickelt mit einer Supraleiterstruktur mit zwei in einer Doppellage normalleitend verlöteten Bandstücken;

- Fig. 15b: einen schematischen Längsschnitt durch die abgewickelte Supraleiterstruktur der Magnetspule von Fig. 15a;
- Fig. 15c: einen schematischen Querschnitt durch die Supraleiterstruktur von Fig. 15b im Doppelbandbereich.

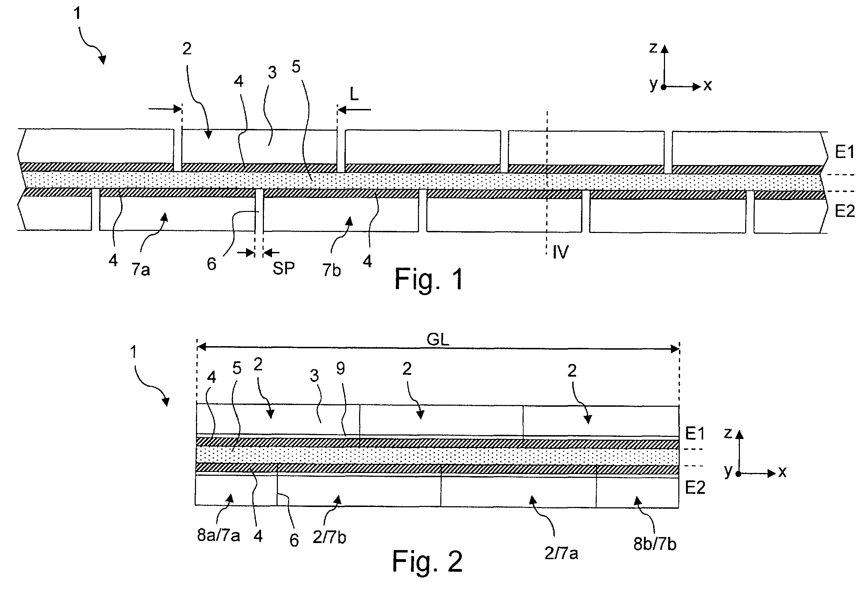

**Fig. 1** zeigt im schematischen Längsschnitt einen Ausschnitt aus einer Supraleiterstruktur 1 für die Magnetspule eines erfindungsgemäßen NMR-Spektrometers. Die Supraleiterstruktur 1 weist eine Vielzahl an miteinander zu einem in einer longitudinalen Richtung (in Fig. 1 von links nach rechts) verlaufenden Leiter verbundenen Bandstücken von bandförmigem Supraleiter auf, wobei der Ausschnitt der Figur hier nur so genannte verkettete Bandstücke 2 umfasst. Im Ausschnitt sind insgesamt elf aufeinanderfolgend miteinander verbundene, verkettete Bandstücke 2 teilweise oder ganz dargestellt (Zur Vereinfachung ist in der Figur nur eines der Bandstücke mit dem Bezugszeichen 2 markiert).

Jedes Bandstück 2 weist ein Substrat 3 (etwa aus Stahlblech) und eine auf dem Substrat 3 abgeschiedene, supraleitende Schicht 4 auf. Die Bandstücke 2 sind hier in zwei Ebenen (oder Lagen) E1, E2 angeordnet; die Bandstücke 2 in der oberen Ebene E1 sind mit ihren supraleitenden Schichten 4 nach unten (auf die untere Ebene E2 zu) orientiert, und die Bandstücke 2 in der unteren Ebene E2 sind mit ihren supraleitenden Schichten 4 nach oben (auf die obere Ebene E1 zu) orientiert; die supraleitenden Schichten 4 sind also einander zugewandt. Zwischen den Bandstücken 2 der verschiedenen Ebenen E1, E2 ist eine Lotschicht 5, die hier aus einer silberhaltigen Legierung besteht, angeordnet.

Zwischen benachbarten Bandstücken 2 der gleichen Ebene E1, E2 liegt in der gezeigten Ausführungsform jeweils ein Spalt 6 mit gegenüber der Länge L der Bandstücken 2 sehr viel geringerer Spaltbreite SP. Die Supraleiterstruktur 1 ist in gezeigten Ausschnitt in Erstreckungsrichtung (x-Richtung) periodisch aufgebaut (sowohl in jeder Ebene E1, E2 als auch insgesamt); insbesondere weisen hier alle verketteten Bandstücke 2 die gleiche Länge L auf und die Spalten 6 die gleiche Spaltbreite SP.

Man beachte, dass in der Figur 1 (und auch in den nachfolgenden Figuren) keine maßstabsgetreuen Dimensionen zu sehen sind, sondern viele Strukturelemente vergrößert dargestellt sind, um deren Erkennbarkeit zu erleichtern. In Erstreckungsrichtung x der Supraleiterstruktur 1 haben die Bandstücke 2 erfindungsgemäß je eine Länge L von zwanzig Metern oder mehr; Spaltbreiten SP (in x-Richtung) betragen typischerweise 5 mm oder weniger. Die Breite der Bandstücken 2 senkrecht zur Zeichenebene von Fig. 1 (y-Richtung) liegt typischerweise zwischen 2 mm und 6 cm, und die Höhe der Bandstücken 2 in z-Richtung liegt typischerweise im Bereich 200 µm oder weniger, meist bei ca. 100 µm oder weniger. Die Dicke einer supraleitenden Schicht 4 (in z-Richtung) beträgt meist einige µm, und die Dicke einer typischen Lotschicht 5 liegt meist im Bereich 100 µm oder weniger, oft 25 µm oder weniger.

Die Supraleiterstruktur 1 dient dazu, einen elektrischen Strom in ihrer Erstreckungsrichtung x (in longitudinaler Richtung) zu transportieren. Dafür sind die Bandstücke 2 als erfindungsgemäß verkettete Bandstücken 2 ausgebildet. Jedes verkettete Bandstück 2 überlappt in x-Richtung mit hier zwei weiteren Bandstücken 7a, 7b (die hier ihrerseits verkettete Bandstücke sind); die weiteren Bandstücke 7a, 7b sind mit dem Bandstück 2 überlappend verbunden. Die Länge L des verketteten Bandstücks 2 wird dabei von den beiden Bandstücken 7a, 7b zusammen im Wesentlichen vollständig überlappt; lediglich im Bereich des Spalts 6 zwischen den weiteren Bandstücken 7a, 7b besteht in der gezeigten Ausführungsform keine Überlappung. Der Spalt 6 liegt hier mittig bezüglich des verketteten Bandstücks 2, so dass die Überlapplängen mit den Bandstücken 7a, 7b jeweils ungefähr L/2 betragen.

Ein in Erstreckungsrichtung der Supraleiterstruktur 1 (x-Richtung) zu transportierender elektrischer Strom im weiteren Bandstück 7a (bzw. dessen supraleitender Schicht 4) kann über eine sehr große Fläche in das verkettete Bandstück 2 übertreten (transversaler Stromfluss in z-Richtung), bevor der Spalt 6 einen weiteren Stromfluss in Erstreckungsrichtung x blockiert. Der ohmsche Widerstand an diesem Übergang ist entsprechend gering. Im verketteten Bandstück 2 kann der Stromfluss dann den Spalt 6 passieren. Anschließend kann der Strom in ähnlicher Weise in das weitere Bandstück 7b übertreten, um den nächsten Spalt zu überbrücken, und so fort.

Die **Figur 2** zeigt ebenfalls in einem Längsschnitt eine Supraleiterstruktur 1 für eine Magnetspule eines erfindungsgemäßen NMR-Spektrometers, mit hier genau fünf verketteten Bandstücken 2 und zwei randständigen Bandstücken 8a, 8b; die Supraleiterstruktur 1 erstreckt sich in x-Richtung. Die Spalte 6 zwischen den innerhalb der beiden Ebenen (Lagen) E1, E2 benachbarten Bandstücken 2, 8a, 8b weisen in dieser Ausführungsform eine verschwindende Spaltbreite (in x-Richtung) auf.

Die in der oberen Ebene E1 jeweils links und rechts äußeren, verketteten Bandstücke 2 sind mit ihren supraleitende Schichten 4 jeweils einem der randständigen Bandstück 8a, 8b und einem verketteten Bandstück 2 als weitere Bandstücke 7a, 7b zugewandt bzw. über die Lotschicht 5 mit diesen überlappend verbunden. Die randständigen Bandstücke 8a, 8b werden hier vom jeweils gegenüberliegenden, äußeren verketteten Bandstück 2 in x-Richtung vollständig überlappt.

In der gezeigten Ausführungsform ist auch eine Pufferschicht 9 der Bandstücke 2, 8a, 8b eingezeichnet, die beispielsweise CeO2 enthält, und jeweils zwischen dem Substrat 3 und der supraleitenden Schicht 4 angeordnet ist.

Die Gesamtlänge GL der Supraleiterstruktur 1 beträgt in der in Fig. 2 gezeigten Ausführungsform ca.1200 m.

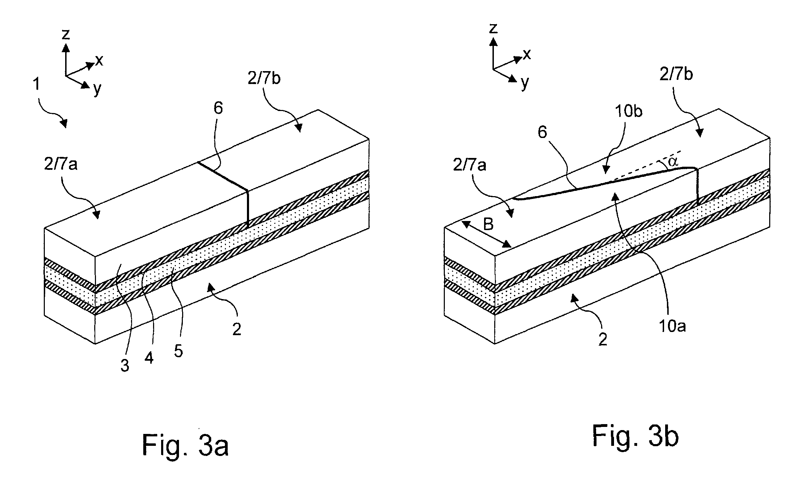

Die **Figur 3a** zeigt in einer schematischen Schrägansicht einen Ausschnitt aus einer Supraleiterstruktur 1 für eine Magnetspule eines erfindungsgemäßen NMR-Spektrometers, beispielsweise einer Supraleiterstruktur wie in Fig. 1 gezeigt, im Bereich eines Spalts 6 zwischen zwei in der oberen Ebene der Supraleiterstruktur 1 benachbarten, verketteten Bandstücken 2; diese beiden Bandstücke stellen weitere Bandstücke 7a, 7b zum Bandstück 2 in der unteren Ebene dar. In der gezeigten Ausführungsform verläuft der Spalt 6 quer zur (senkrecht zur) Erstreckungsrichtung x der Supraleiterstruktur 1; diese Spaltgeometrie ist besonders einfach herzustellen.

Es ist allerdings auch möglich, den Spalt 6 schräg zur Erstreckungsrichtung (x-Richtung) auszubilden, wie in der Supraleiterstruktur 1 von **Figur 3b** gezeigt. Die Enden 10a, 10b der Bandstücken 2 bzw. 7a, 7b in der oberen Ebene der Supraleiterstruktur 1 verjüngen sich hier jeweils in Richtung auf das jeweils andere Bandstück 2 bzw. 7b, 7a zu; die Enden 10a, 10b ergänzen sich aber im Wesentlichen zur vollen Breite B der beiden Bandstücke 2 bzw. 7a, 7b. Der verbleibende Spalt 6 verläuft größtenteils mit einem Winkel α von ca. 15° gegenüber der Erstreckungsrichtung x.

Man beachte, dass eine Spaltbreite SP im Rahmen der Erfindung stets in Erstreckungsrichtung x gemessen wird, auch wenn der Spalt 6 schräg zur Erstreckungsrichtung x verlaufen sollte. Falls die Spaltbreite entlang des Spalts 6 variieren sollte, bestimmt sich die Spaltbreite SP des Spalts insgesamt grundsätzlich nach der größten auftretenden Spaltbreite entlang des Spalts 6.

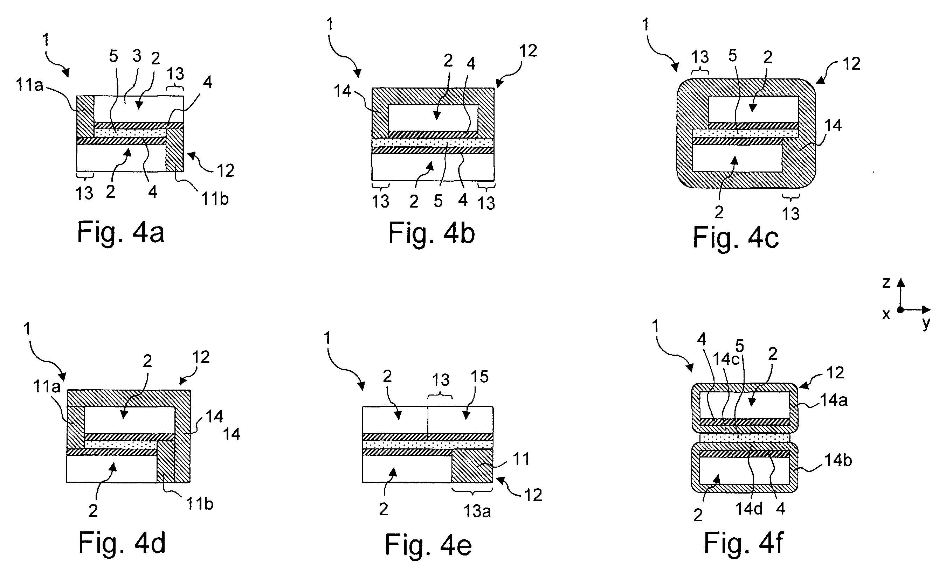

In den Figuren 4a bis 4f sind Querschnitte (vgl. die Ebene IV in Fig. 1) durch verschiedene Ausführungsformen von Supraleiterstrukturen 1 für eine Magnetspule eines erfindungsgemäßen NMR-Spektrometers dargestellt, wobei der Querschnitt an einer Position entfernt von den Spalten gewählt ist.

Wie aus **Fig. 4a** ersichtlich, können die gegenüberliegenden, hier gleich breiten Bandstücke 2 einer Supraleiterstruktur 1 seitlich (in y-Richtung) gegeneinander versetzt angeordnet werden, so dass quer zur Erstreckungsrichtung x zwei Überstandbereiche 13 verbleiben. Diese werden mit zwei Shunt-Elementen 11a, 11 b, die bevorzugt aus Kupfer gefertigt sind, kontaktiert, so dass zwei normalleitende Strompfade parallel zu den supraleitenden Schichten 4 eingerichtet sind und dadurch eine Shunt-Struktur 12 ausgebildet wird. Zwischen den supraleitenden Schichten 4 (hier nicht jedoch unter den Shunt-Elementen 11 a, 11 b) ist ein silberhaltiges Lot 5 für einen guten elektrischen Kontakt vorgesehen.

In der Ausführungsform der Supraleiterstruktur 1 von **Fig. 4b** sind zwei unterschiedlich breite Bandstücke 2 verbaut. Das schmalere, obere Bandstück 2 ist mittig auf dem unteren, breiteren Bandstück 2 platziert und wird von einer Shunt-Schicht 14 umhüllt, die auch die Überstandbereiche 13 des unteren Bandstücks 2 bedeckt. In der gezeigten Ausführungsform kontaktiert die Shunt-Schicht 14 (die bevorzugt aus Kupfer gefertigt ist) dabei eine Lotschicht 5, wodurch ein guter elektrischer Kontakt zu beiden supraleitenden Schichten 4 sichergestellt ist. Dadurch kann die Shunt-Schicht 14 als Shunt-Struktur 12 für beide Bandstücke 2 gut eingesetzt werden.

In der Ausführungsform der Supraleiterstruktur von **Fig. 4c** sind die zwei gegenüberliegenden, aber seitlich gegeneinander verschobenen Bandstücke 2 vollständig von einer Shunt-Schicht 14 umhüllt, die entsprechend auch die Überstandbereiche 13 (hier über die Lotschicht 5) kontaktiert. Die Shunt-Schicht 14 agiert hier nicht nur als Shunt-Struktur 12, sondern auch als mechanische Klammer für die beiden Bandstücke 2.

Die **Fig. 4d** illustriert eine Variante der Ausführungsform von Fig. 4a, wobei eine zusätzliche Shunt-Schicht 14 L-förmig die beiden Shunt-Elemente 11a, 11b und das obere Bandstück 2 umgreift. Dadurch kann die Querschnittsfläche der gesamten Shunt-Struktur 12 erhöht werden.

Es ist auch möglich, ein in der **Fig. 4e** unten angeordnetes Bandstück 2 mit einem oberen Bandstück 2 seitlich in y-Richtung nur teilweise zu überlappen, so dass ein Überstandbereich 13 verbleibt, und diesen Überstandbereich 13 mit einem Behelfsbandstück 15 zu kontaktieren. Das Behelfsbandstück 15 kann ein verkettetes Bandstück der Supraleiterstruktur 1 sein oder auch nicht. Mit dem Behelfsbandstück 15 wird ein Behelfsüberstandbereich 13a geschaffen, der mit einem Shunt-Element 11 kontaktiert werden kann, wobei die Breite (in y-Richtung) des Behelfsüberstandbereichs 13a durch die Breite des Behelfsbandstücks 15 praktisch beliebig eingestellt werden kann. Dadurch kann die Leistungsfähigkeit der Shunt-Anordnung 12 eingestellt werden.

Weiterhin ist es möglich, eine Shunt-Anordnung 12 durch zwei Shunt-Schichten 14a, 14b (hier aus Kupfer) auszubilden, die jeweils für sich eines der beiden Bandstücke 2 umhüllen, und die beiden Shunt-Schichten 14a, 14b über eine Lotschicht 5 zu verbinden, vgl. **Fig. 4f****.** Dadurch liegen effektiv zwischen den einander gegenüberliegenden supraleitenden Schichten 4 der beiden Bandstücke 2 zwei Kupferschichten 14c, 14d und eine hier silberhaltige Lotschicht 5.

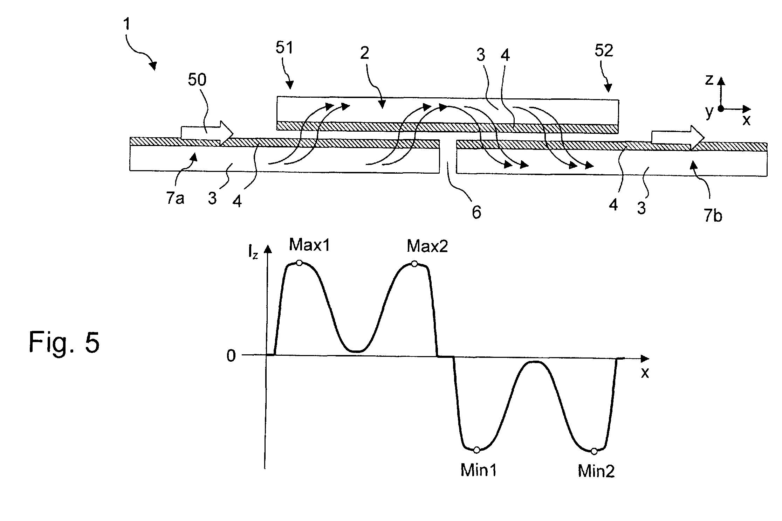

Die **Fig. 5** illustriert den Fluss von in einer erfindungsgemäßen Supraleiterstruktur 1 in Erstreckungsrichtung x transportiertem elektrischen Strom 50. Die Supraleiterstruktur 1 umfasst zumindest ein verkettetes Bandstück 2 und zwei mit diesem verbundene, weitere Bandstücke 7a, 7b, die insgesamt mit dem Bandstück 2 über dessen gesamte Länge in x-Richtung bis auf einen in y-Richtung verlaufenden Spalt 6 überlappen. Im Diagramm ist der transversale Stromfluss I_{z}, also der Stromfluss in z-Richtung senkrecht in die supraleitende Schicht 4 des Bandstücks 2 hinein (bzw. bei negativem Vorzeichen aus dieser hinaus), als Funktion der x-Position dargestellt. Für eine bessere Übersichtlichkeit wurden die Bandstücke 2, 7a, 7b im oberen Teil der Figur etwas gespreizt dargestellt.

Der transversale Strom I_{z} hat zunächst in der Nähe des in der Fig. 5 linken Endes 51 des Bandstücks 2 ein Maximum Max1, da in diesem Bereich der von links durch das weitere Bandstück 7a fließende Strom erstmals auch das Bandstück 2 erreichen und nutzen kann. Vor dem Spalt 6 muss schließlich aller (verbliebene) Strom vom weiteren Bandstück 7a in das Bandstück 2 wechseln, was zu einem weiteren Maximum Max2 führt. Man beachte, dass Max1 und Max2 typischerweise gleich groß sind. Direkt über dem Spalt 6 zwischen den beiden weiteren Bandstücken 7a, 7b (die bezüglich z die gleiche Position haben, also in einer Ebene sind) ist kein transversaler Stromfluss möglich. Nach dem Spalt 6 kann erstmals Strom in das weitere Bandstück 7b fließen, was ein erstes Minimum Min1 des transversalen Stroms I_{z} zu Folge hat. Kurz vor dem rechten Ende 52 des Bandstücks 2 muss schließlich aller (verbliebene) Strom in das weitere Bandstück 7b wechseln, was an einem weiteren Minimum Min2 erkennbar ist.

In ähnlicher Weise wie ein Spalt 6 kann auch eine Inhomogenität des kritischen Stroms (etwa ein normalleitender Fehlerbereich in einer supraleitenden Schicht 4) vom Strom 50 umgangen werden.

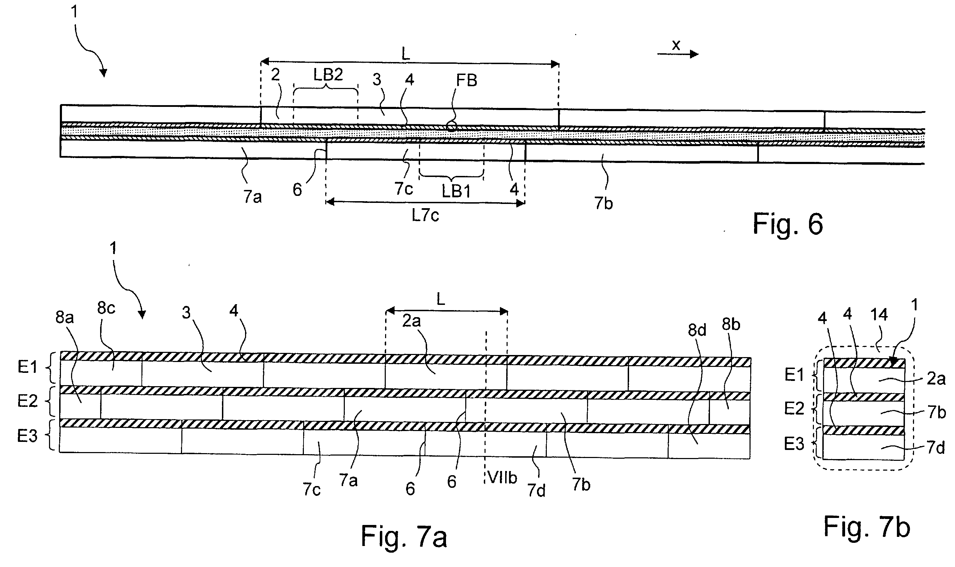

Die **Fig. 6** zeigt eine weitere Ausführungsform einer Supraleiterstruktur 1 für die Erfindung, bei der Bandstücke 2, 7a, 7b, 7c unterschiedlicher Länge (in Erstreckungsrichtung x) verbaut wurden. Die Bandstücke 2, 7a, 7b, 7c weisen jeweils ein Substrat 3 und eine supraleitende Schicht 4 auf.

Das mit Bezugszeichen 2 markierte verkettete Bandstück ist hier mit insgesamt drei weiteren Bandstücken überlappend verbunden, nämlich den weiteren Bandstücken 7a, 7b und 7c; diese drei Bandstücken 7a, 7b und 7c überlappen zusammen mit der gesamten Länge L des verketteten Bandstücks 2. Die Länge L des verketteten Bandstücks 2 ist hier ca. 1,5x so groß wie die Länge L7c des weiteren Bandstücks 7c. Durch Verwendung unterschiedlich langer Bandstücken 2, 7a, 7b, 7c in der Supraleiterstruktur 1 kann Verschnitt beim teuren bandförmigen Supraleiter vermieden oder zumindest verringert werden.

Allerdings sollte bei der Fertigung der Supraleiterstruktur 1 darauf geachtet werden, dass um einen bekannten Fehlerbereich in einem Bandstück herum ein diesen Fehlerbereich überbrückendes Bandstück frei von bekannten Fehlerbereichen ist. Beispielsweise ist das weitere Bandstück 7c, welches einen bekannten Fehlerbereich FB des verketteten Bandstücks 2 (etwa eine normalleitende Stelle in der Supraleiterschicht 4 des verketteten Bandstücks 2) überbrückt, in einem ersten longitudinalen Bereich LB1, der sich hier vor und hinter dem Fehlerbereich FB über jeweils 10 m erstreckt, frei von bekannten Fehlerbereichen.

Ebenso sollte darauf geachtet werden, dass um einen Spalt herum ein diesen Spalt überbrückendes Bandstück frei von bekannten Fehlerbereichen ist. Beispielsweise ist um den in der Fig. 6 mit Bezugszeichen 6 versehenen Spalt zwischen den weiteren Bandstücken 7a, 7c herum das verkettete Bandstück 2 in einem zweiten longitudinalen Bereich LB2, der sich hier vor und hinter dem Spalt 6 über jeweils 10 m erstreckt, frei von bekannten Fehlerbereichen (etwa normalleitenden Stellen in der Supraleiterschicht 4 des verketteten Bandstücks 2).

Bei Berücksichtigung dieser Grundsätze in der Planung, welche Bandstücke wo miteinander überlappend verbunden werden, können auch Bandstücke mit bekannten Fehlerbereichen ohne Weiteres eingesetzt werden; die bekannten Fehlerbereiche können ähnlich wie Spalte überbrückt werden und beeinträchtigen dann die Stromtragfähigkeit der Supraleiterstruktur insgesamt nicht. Ausschuss aufgrund von bekannten Fehlerbereichen in Bandstücken kann so minimiert werden.

Man beachte, dass hier das weitere Bandstück 7c nicht als verkettetes Bandstück gilt, da es nur mit einem Bandstück, nämlich dem Bandstück 2 überlappt. Hingegen sind die weiteren Bandstücke 7a, 7b ihrerseits verkettete Bandstücke im Sinne der Erfindung, und die Bandstücke 7a, 2 und 7c können als aufeinanderfolgend miteinander verbundene, verkette Bandstücke angesehen werden.

Während in den Figuren 1 bis 6 jeweils Supraleiterstrukturen mit einem Doppelband-Aufbau gezeigt wurden, ist in **Fig. 7a** eine Supraleiterstruktur 1 für die Erfindung dargestellt, die einen Mehrfachband-Aufbau mit Bandstücken in mehr als zwei Ebenen (Lagen), nämlich hier drei Ebenen (Lagen) E1, E2, E3, aufweist. Die Bandstücke weisen wiederum jeweils ein Substrat 3 und eine supraleitende Schicht 4 auf.

In der gezeigten Ausführungsform wird die Supraleiterstruktur 1 durch eine Vielzahl von mehrfach verketteten Bandstücken 2a (von denen zur Vereinfachung nur eines in der Figur 7a markiert ist) und vier randseitigen Bandstücken 8a-8d gebildet. Beispielhaft soll das mit Bezugszeichen 2a markierte, mehrfach verkettete Bandstück nun näher betrachtet werden:
Das mehrfach verkettete Bandstück 2a, das in der obersten Ebene E1 angeordnet ist, wird in der mittleren Ebene E2 zusammen von den weiteren Bandstücken 7a, 7b über seine gesamte Länge L (mit Ausnahme des Spaltes 6 zwischen den Bandstücken 7a, 7b) überlappt. Die weiteren Bandstücke 7a, 7b bilden somit ein erstes Set von weiteren Bandstücken 7a, 7b, mit denen das mehrfach verkettete Bandstück 2a überlappend verbunden ist.

Das mehrfach verkettete Bandstück 2a wird weiterhin in der unteren Ebene E3 zusammen von den weiteren Bandstücken 7c, 7d über seine gesamte Länge L (mit Ausnahme des Spaltes 6 zwischen den Bandstücken 7c, 7d) überlappt. Die weiteren Bandstücke 7c, 7d bilden somit ein zweites Set von weiteren Bandstücken 7c, 7d, mit denen das mehrfach verkettete Bandstück 2a überlappend verbunden ist.

Man beachte, dass die weiteren Bandstücke 7a-7d ihrerseits mehrfach verkettete Bandstücke sind, die von jeweils zwei Sets von weiteren Bandstücken jeweils vollständig (mit Ausnahme von Spalten 6) überlappt werden.

Die Spalte 6 zwischen den weiteren Bandstücken 7c, 7d und 7a, 7b liegen bei etwa 1/3 und 2/3 der Länge L des mehrfach verketteten Bandstücks 2a, und sind somit gleichmäßig verteilt über die Länge L des mehrfach verketteten Bandstücks 2a angeordnet. Dadurch stehen für Stromübergänge stets Längen entsprechend ca. 1/3 der Länge L des mehrfach verketteten Bandstücks 2a zur Verfügung.

In der gezeigten Ausführungsform sind die supraleitenden Schichten 4 aller Bandstücke zur gleichen Seite (nach oben) orientiert. Ein solcher Aufbau hat Vorteile bezüglich der Kraftverteilung in einer mit der Supraleiterstruktur 1 gewickelten Magnetspule. Der transversaler Stromausgleich zwischen den Ebenen E1, E2, E3 kann dann mittels einer Shunt-Schicht 14, etwa aus Kupfer, die die Supraleiterstruktur 1 umschließt, unterstützt werden, vgl. **Fig. 7b****,** die einen Querschnitt aus der Fig. 7a bei Schnittebene VIIb zeigt. Elektrischer Strom der mittleren supraleitenden Schicht 4 aus der Ebene E2 kann beispielsweise seitlich in die gut leitende Shunt-Schicht 14 übertreten und (an anderer longitudinaler Position) von dieser beispielsweise wieder seitlich in die supraleitende Schicht 4 der unteren Ebene E3 eintreten.

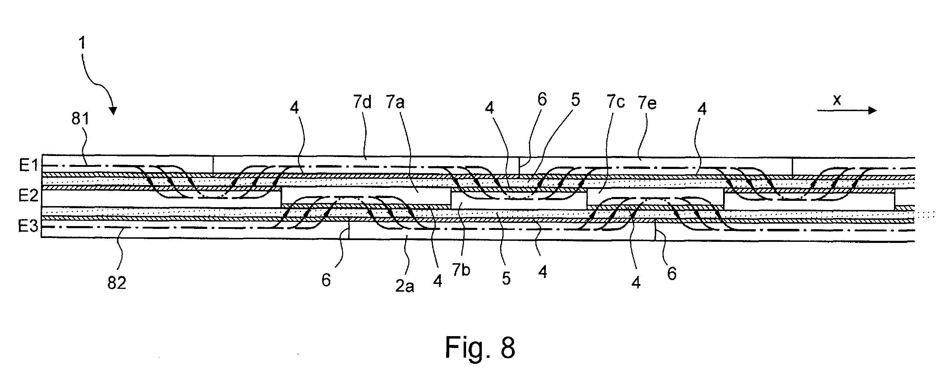

Ein direkterer transversaler Stromübergang zwischen Bandstücken verschiedener Ebenen E1, E2, E3 kann eingerichtet werden, indem in der mittleren Ebene E2 einer Supraleiterstruktur 1 mit 3-fach-Bandaufbau die Orientierung der supraleitenden Schichten 4 alterniert, also von Bandstück zu Bandstück in der Ebene E2 wechselt, wie in **Fig. 8** dargestellt.

In der gezeigten Ausführungsform sind die supraleitenden Schichten 4 der Bandstücke der oberen Ebene (Lage) E1 und der unteren Ebene (Lage) E3 jeweils zur mittleren Ebene (Lage) E2 hin orientiert. Die Bandstücke der mittleren Lage E2 sind jeweils so orientiert, dass diese mit ihren supraleitenden Schichten 4 jeweils derjenigen Ebene E1, E3 zugewandt sind, wo gerade ein Spalt 6 auftritt.

Beispielhaft soll dies an dem mit dem Bezugszeichen 2a versehenen, mehrfach verketteten Bandstück der unteren Ebene E3 verdeutlicht werden. Dieses mehrfach verkettete Bandstück 2a wird von einem Set der weiteren Bandstücken 7a, 7b, 7c der mittleren Ebene E2 und von einem Set der weiteren Bandstücken 7d, 7e der oberen Ebene E1 überlappt. Um die Spalten 6 an der linken und rechten Seite des mehrfach verketteten Bandstücks 2a zu überbrücken, sind die weiteren Bandstücken 7a und 7c mit ihren supraleitenden Schichten 4 dem mehrfach verketteten Bandstück 2a (und dessen supraleitender Schicht 4) zugewandt. Um den Spalt 6 zwischen den weiteren Bandstücken 7d, 7e zu überbrücken, ist das weitere Bandstück 7b mit seiner supraleitenden Schicht 4 den weiteren Bandstücken 7d, 7e (und deren supraleitenden Schichten 4) zugewandt. Ein guter elektrischer Kontakt kann jeweils über ein Lot 5 mit guter Leitfähigkeit (das bevorzugt edelmetallhaltig ist) zwischen den supraleitenden Schichten 4 hergestellt werden.

In der Supraleiterstruktur 1 von Fig. 8 kann der elektrische Strom sodann über zwei im Wesentlichen supraleitende Strompfade 81, 82 in longitudinaler Richtung (x-Richtung) fließen. Im Strompfad 81 wechselt der Stromfluss zwischen der oberen Ebene E1 und der mittleren Ebene E2, wobei der Strom bei jeweils bei Spalten 6 in der oberen Ebene E1 über die mittlere Ebene E2 transversal ausweicht. Im Strompfad 82 wechselt der Stromfluss zwischen der unteren Ebene E3 und der mittleren Ebene E2, wobei der Strom jeweils bei Spalten 6 in der unteren Ebene E3 über die mittlere Ebene E2 transversal ausweicht.

Man beachte, dass in dieser Ausführungsform die Bandstücke der mittleren Ebene E2 jeweils ca. ½ mal so lang sind wie die Bandstücke der äußeren Ebenen E1, E3.

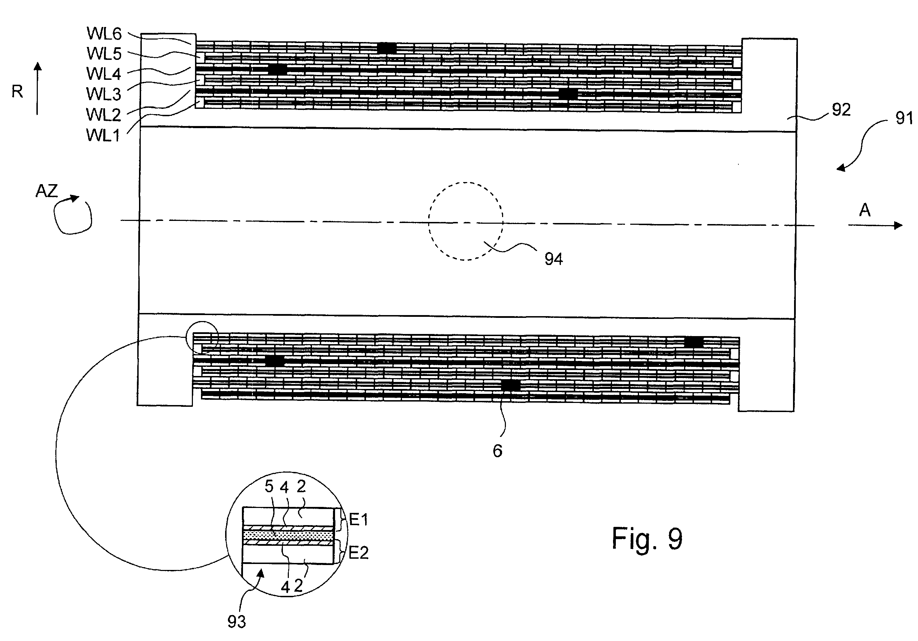

Supraleiterstrukturen, wie sie in den Figuren 1 bis 8 vorgestellt wurden, werden erfindungsgemäß in einer NMR-Magnetspule eines NMR-Spektrometers verwendet. Die **Fig. 9** zeigt beispielhaft eine NMR-Magnetspule 91 für die Erfindung mit einer Spulensektion, die mit einer Supraleiterstruktur im Doppelband-Aufbau (wie beispielsweise in Fig. 1 bis Fig. 6 dargestellt) gewickelt ist. Die Wicklung erfolgt hier nach Art einer Solenoidspule.

Das Doppelband 93, vgl. den vergrößerten Ausschnitt unten in Fig. 9, weist verkette Bandstücke 2 in zwei Ebenen E1, E2 auf, wobei die verketteten Bandstücke 2 mit ihren supraleitenden Schichten 4 einander zugewandt überlappend verbunden sind, und wobei zwischen die supraleitenden Schichten 4 ein Lot 5 eingebracht ist.

Auf einem Spulenträger 92 wird das Doppelband 93 mit einer Vielzahl von radialen Wickellagen WL1-WL6 (hier dargestellt sechs Wickellagen) aufgewickelt, wobei jede Wickellage WL1-WL6 wiederum eine Vielzahl von axial aufeinander folgenden Wicklungen aufweist. Mit dem gewickelten Doppelband 93 wird in einem Probenvolumen 94 in einer axialen Bohrung des Spulenträgers 92 ein homogenes Magnetfeld in axialer Richtung erzeugt. Das Probenvolumen 94 beträgt dabei wenigstens 1 cm³, bevorzugt wenigstens 10 cm³ und weist eine Homogenität von 100 ppm oder besser, bevorzugt 10 ppm oder besser auf, jeweils ohne Shimmen bzw. vor einem Shimvorgang, d.h. ohne weitere Homogenisierung durch mit unabhängigen Shimströmen betriebenen Shimspulen und/oder ferromagnetische Shimplättchen; nach einem Shimmen können noch weit bessere Homogenitäten im Probenvolumen 94 erreicht werden, etwa 10⁻⁹ oder besser, bevorzugt 10⁻¹⁰ oder besser. Im Probenvolumen 94 kann bevorzugt ein Magnetfeld von 10 Tesla oder mehr, bevorzugt 20 Tesla oder mehr erzeugt werden. Das Probenvolumen 94 ist hier als kugelförmig angedeutet; man beachte, dass das Probenvolumen im Allgemeinen auch einen zylindrischen Raum, typischerweise mit einer kreisförmigen Grundfläche mit einem Radius von 2,5 bis 7,5 mm und einer Längserstreckung in axialer Richtung von wenigstens 20 mm, bevorzugt wenigstens 40 mm, einnehmen kann.

Im Doppelband 93 treten Spalten (Stöße) 6 auf, wobei deren Positionen in der Fig. 9 jeweils mit einer schwarzen Markierung der Wickelung kenntlich gemacht ist. Im gezeigten Ausführungsbeispiel treten im gezeigten Längsschnitt sechs Spalten 6 auf.

Um mechanische Belastungen durch Lorenzkräfte in einer NMR-Magnetspule, etwa der NMR-Magnetspule 91, gering zu halten, wird die Supraleiterstruktur mit der Abfolge ihrer Spalten 6 so geplant (etwa durch die Auswahl der Längen der aneinander gestückelten Bandstücken), dass mechanische Schwachstellen vermieden werden. Spalten 6 sollten erfindungsgemäß insbesondere nicht radial (vgl. Radiusrichtung R) übereinander liegen, und auch nicht axial (vgl. die axiale Richtung A) nebeneinander liegen. Spalten 6 treten jeweils zwischen zwei in derselben (Band-)Ebene E1, E2 aufeinanderfolgenden Bandstücken, insbesondre zwei weiteren Bandstücken, die mit demselben verketteten Bandstück verbunden sind, auf.

Im Allgemeinen sollten zwei Spalten 6, die in Wicklungen derselben Wickellage WL1-WL6 auftreten, azimutal (vgl. azimutale Richtung AZ) beabstandet sein, insbesondere um wenigstens 30°. Am einfachsten kann dieses Kriterium erfüllt werden, wenn je Wickellage WL1-WL6 maximal ein Spalt 6 vorgesehen ist. Ebenfalls bevorzugt ist es, wenn Spalte 6 in derselben Wickellage WL1-WL6 nicht in axial unmittelbar benachbarten Wicklungen auftreten; bevorzugt sollten hier wenigstens zwei, besonders bevorzugt wenigstens drei vollständige Wicklungen zwischen den Spalten 6 liegen.

Weiterhin sollte im Allgemeinen bei Spalten 6 in verschiedenen Wickellagen WL1-WL6, die jedoch an der gleichen axialen Position auftreten, wiederum darauf geachtet werden, dass diese Spalten 6 azimutal beabstandet sind, bevorzugt um wenigstens 30°. Ebenfalls bevorzugt ist es, wenn Spalten 6 in verschiedenen Wickellagen WL1-WL6, die bei der gleichen axialen Position auftreten, nicht in zueinander benachbarten Wickellagen auftreten.

Besonders bevorzugt ist es, wenn alle Spalten 6 (ungeachtet der Lagenzugehörigkeit oder der azimutalen Position) in axialer Richtung voneinander beabstandet sind, insbesondere um wenigstens die Breiten dreier Wicklungen. Ebenso ist es besonders bevorzugt, wenn alle Spalten 6 (ungeachtet der Lagenzugehörigkeit und der axialen Position) in azimutaler Richtung voneinander beabstandet sind, insbesondere um wenigstens 30°.

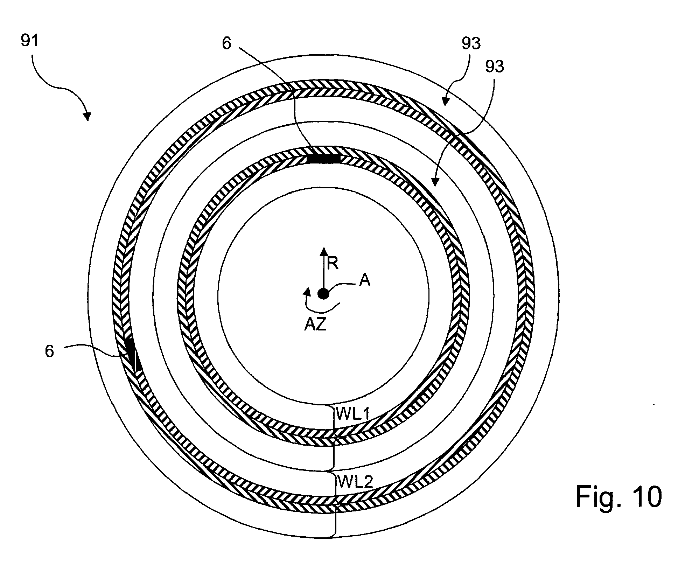

In **Fig. 10** ist eine andere NMR-Magnetspule 91 für die Erfindung im Querschnitt illustriert. Diese Magnetspule 91 weist zwei Wickellagen WL1, WL2 eines Doppelbandes 93 auf. In dieser Magnetspule 91 treten im gezeigten Querschnitt zwei mit schwarzen Kästchen markierte Spalten 6 auf, die azimutal voneinander beabstandet sind (hier um ca. 100 °), um eine mechanische Schwächung der Magnetspule 91 durch die Spalten 6 gering zu halten.

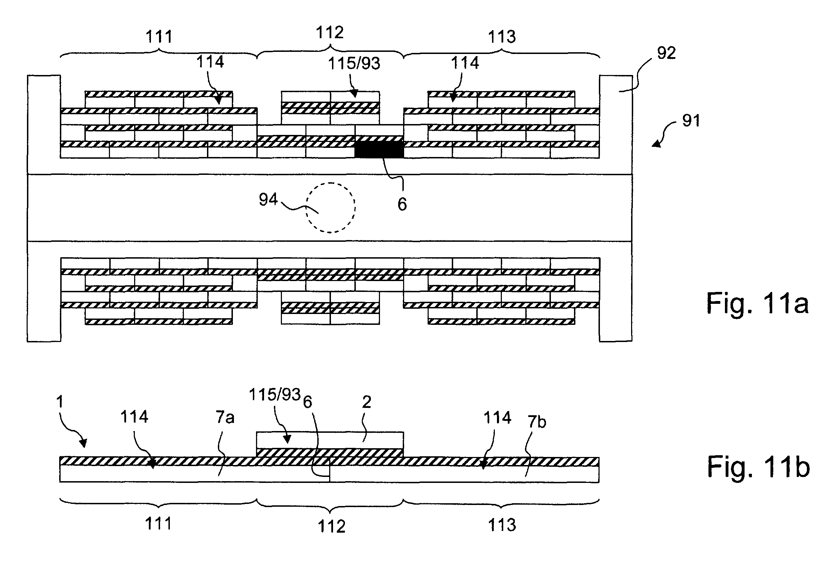

Fig. 11a zeigt eine andere Ausführungsform einer NMR-Magnetspule 91 für ein erfindungsgemäßes NMR-Spektrometer im Längsschnitt. Die NMR-Magnetspule 91 weist eine Spulensektion mit drei (elektrisch als in Serie geschaltet anzusehenden) Teilsektionen 111, 112, 113 auf, die auf einen Spulenträger 92 gewickelt sind. Den Aufbau der verwickelten, zusammenhängenden Supraleiterstruktur 1 zeigt die **Fig. 11b****.**

In der ersten, linken Teilsektion 111 ist die Supraleiterstruktur 1 mit einem Einfachband 114 ausgebildet. In der zweiten, mittleren Teilsektion 112 ist die Supraleiterstruktur mit einem Mehrfachband 115, nämlich einem Doppelband 93 ausgebildet; diese Teilsektion 112 enthält einen Spalt 6. Die dritte, rechte Teilsektion 113 ist wiederum als Einfachband 114 ausgebildet.

Die als Einfachband 114 verlaufenden Abschnitte der Spulensektion werden von weiteren Bandstücken 7a, 7b ausgebildet, die im Bereich des als Doppelband 93 verlaufenden Abschnitts der Spulensektion mit einem verketteten Bandstück 2 überlappend verbunden sind. Das verkettete Bandstück 2 agiert hier also als ein in der Spulensektion gelegenes Joint zwischen den weiteren Bandstücken 7a, 7b.

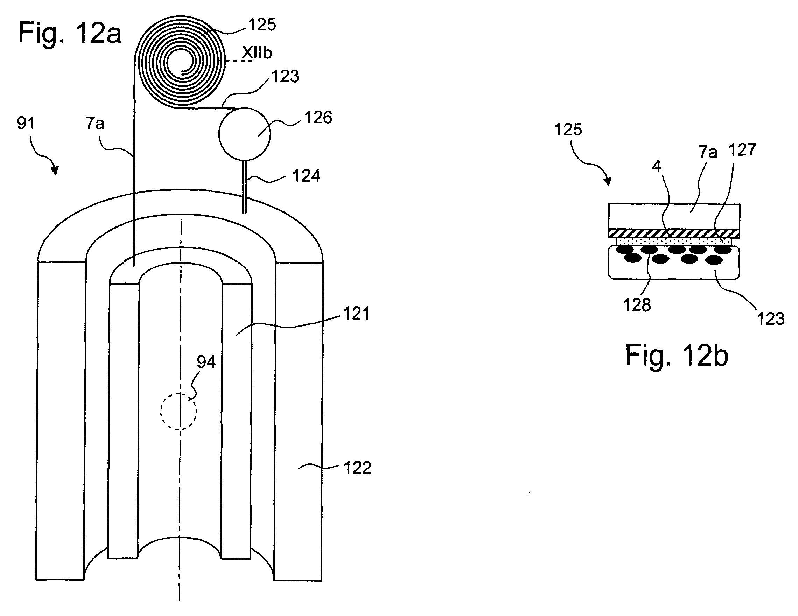

**Fig. 12a** illustriert eine NMR-Magnetspule 91 für ein erfindungsgemäßes NMR-Spektrometer, mit zwei radial ineinander geschachtelten Spulensektionen 121, 122, die seriell supraleitend verbunden sind.

Die innen liegende, erste Spulensektion 121 ist mit einer Supraleiterstruktur aus Bandstücken wie beispielsweise in den Figuren 1 bis 8 beschrieben gewickelt; die dortigen Bandstücke sind mit Hochtemperatur-Supraleitermaterial, hier YBCO, beschichtet, so dass die erste Spulensektion 121 eine HTS-Sektion 121 darstellt.

Die zweite, außen liegende Spulensektion 122 ist mit einem LTS-Draht 124 enthaltend Filamente aus Tieftemperatur-Supraleitermaterial, hier Nb3Sn, gewickelt, so dass diese zweite Spulensektion eine LTS-Sektion 122 darstellt.

Die Supraleiterstruktur der HTS-Sektion 121 ist mit einem Abschnitt eines weiteren Bandstücks 7a aus der ersten Spulensektion 121 herausgeführt. Dieses weitere Bandstück 7a bildet ein Joint 125 mit einem LTS-Draht 123, hier enthaltend Filamente aus NbTi, aus, wobei das weitere Bandstück 7a und der LTS-Draht 123 über eine Länge von 1 m oder mehr, bevorzugt 10 m oder mehr, überlappend miteinander verbunden sind; der Überlappbereich kann dabei wie dargestellt aufgerollt werden, um einen kompakten Aufbau zu erreichen. Wie in der **Fig. 12b** dargestellt, die einen Querschnitt durch den Überlappbereich des Joints 125 im Schnittbereich Xllb der Fig. 12a zeigt, sind das weitere Bandstück 7a und der LTS-Draht 123 über ein Lot 127 (das typischerweise edelmetallhaltig und/oder kupferhaltig ist) miteinander flächig verbunden. Der LTS-Draht 123 ist in der gezeigten Ausführungsform flach gewalzt und in seinem hier oberen Teil abgeätzt worden, so dass zumindest ein Teil der Filamente 128 vom Lot 127 direkt kontaktiert werden können. Die supraleitende Schicht 4 des weiteren Bandstücks 7a ist dem Lot 127 zugewandt und wird hier ebenfalls vom Lot 127 direkt kontaktiert, wodurch ein besonders niedriger Übergangswiderstand erreicht wird.

Wie wiederum aus Fig. 12a ersichtlich ist, ist der LTS-Draht 123 (NbTi-Draht) mit dem LTS-Draht 124 (Nb3Sn-Draht) der zweiten Spulensektion 122 über ein herkömmliches Joint 126 verbunden.

Mit einer solchen Verjointung ist es möglich, die HTS-Sektion 121 und die LTS-Sektion 122 auf einfache und zuverlässige Weise quasi supraleitend zu verbinden. Insbesondere kann die gesamte NMR-Magnetspule 91 in einem supraleitend kurzgeschlossenen Betriebsmodus ("persistent mode") betrieben werden, wobei zwei Verjointungen wie in Fig. 12 abgebildet und typischerweise auch ein supraleitender Schalter (nicht näher dargestellt) eingesetzt werden.

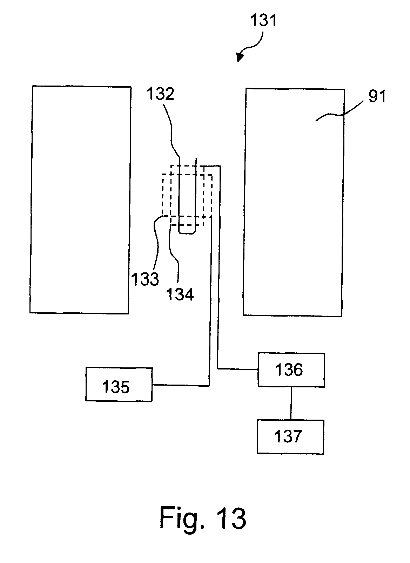

In der **Fig. 13** ist ein erfindungsgemäßes NMR-Spektrometer 131 beispielhaft schematisch dargestellt.

Das NMR-Spektrometer 131 umfasst eine NMR-Magnetspule 91, beispielsweise wie in Fig. 12 oder Fig. 14 oder Fig. 15 dargestellt, die typischerweise in einem Kryostaten angeordnet ist (nicht näher dargestellt). Im magnetischen Zentrum der Magnetspule 91 ist in einem Probenvolumen eine Probe 132 (etwa ein mit einer zu untersuchenden Substanz gefülltes Probenröhrchen) angeordnet. Die Probe 132 ist von einer HF-Sendespule 133 und einer HF-Empfangsspule 134 umgeben (Man beachte, dass in anderen Bauformen auch kombinierte HF-Sende- und Empfangsspulen möglich sind). Mit einem HF-Generator 135 und der Sendespule 133 werden HF-Impulse in die Probe 132 eingestrahlt. Mit einem HF-Detektor 136 und der HF-Empfangsspule 134 wird die Antwort der Probe 132 vermessen. Die Messergebnisse werden mit einer Auswerteeinheit 137 verarbeitet, und beispielsweise in ein NMR-Spektrum umgewandelt.

Ein erfindungsgemäßes NMR-Spektrometer 131 genügt bevorzugt den Anforderungen der hochauflösenden NMR-Spektroskopie.

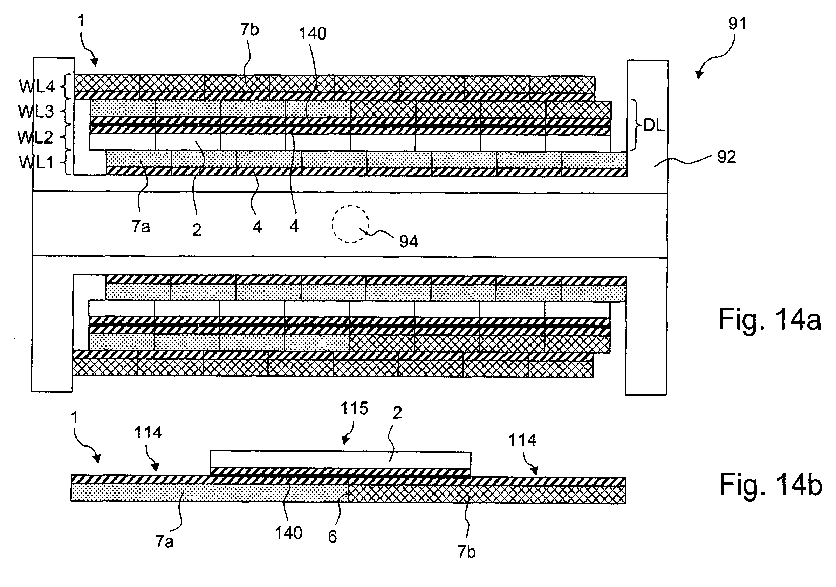

Die **Fig. 14a** zeigt in einem Längsschnitt eine NMR-Magnetspule 91 für ein erfindungsgemäßes NMR-Spektrometer in einer weiteren Ausführungsform. Auf dem Spulenträger 92 ist eine Supraleiterstruktur 1, umfassend ein verkettetes Bandstück 2 und zwei weitere Bandstücke 7a, 7b, nach Art einer Solenoidspule mit hier insgesamt vier Wickellagen WL1-WL4 aufgewickelt. Wie auch aus der abgewickelten Darstellung von **Fig. 14b** ersichtlich, ist die erste Wickellage WL1 als Einfachband 114 durch das weitere Bandstück 7a gewickelt. Die zweite Wickellage WL2 wird durch das verkettete Bandstück 2 gewickelt. Die dritte Wickellage WL3 wird zu einer Hälfte (hier linken Hälfte) durch das weitere Bandstück 7a (gepunktet dargestellt), und zur anderen Hälfte (hier rechten Hälfte) durch das weitere Bandstück 7b (mit Kreuzschraffur dargestellt) gewickelt; die dritte Wickellage WL3 enthält somit einen Spalt 6. Die vierte Wickellage WL4 wird als Einfachband 114 durch das zweite, weitere Bandstück 7b gewickelt. Die Wickellagen WL2 und WL3 bilden eine Doppellage DL bzw. ein Mehrfachband 115. In der Doppellage DL sind die Bandstücke 2 und 7a sowie 2 und 7b miteinander überlappend verbunden, hier miteinander normalleitend verlötet, vgl. die Lötschicht 140.

Die weiteren Bandstücken 7a, 7b sind hier mit ihren supraleitenden Schichten 4 jeweils radial nach innen orientiert, während das verkettete Bandstück 2 mit seiner supraleitenden Schicht 4 radial nach außen orientiert ist; in der Doppellage DL sind sich die supraleitenden Schichten 4 der Wickellagen WL2 und WL3 also einander zugewandt, was einen besonders niedrigen Übergangswiderstand ermöglicht.

Man beachte, dass je nach verfügbarer, fehlerfreier Bandlänge auch zwei oder mehr Wickellagen als Einfachband 114 jeweils innen und/oder außen mit den weiteren Bandstücken 7a, 7b gewickelt werden können. Ebenso kann in einer Spulensektion auch mehrfach wie oben beschrieben von einem Einfachband 114 auf ein Mehrfachband 115 und zurück gewechselt werden.

In der **Fig. 15a** ist eine weitere NMR-Magnetspule 91 für ein erfindungsgemäßes NMR-Spektrometer dargestellt. Auf dem Spulenträger 92, welcher eine Bohrung mit einem Probenvolumen 94 enthält, ist eine Supraleiterstruktur 1 umfassend hier zwei Bandstücke 150, 151 in insgesamt vier Wickellagen WL1, WL2, WL3, WL4 nach Art einer Solenoidspule aufgewickelt. Wie auch aus der abgewickelten Darstellung von **Fig. 15b** ersichtlich ist, ist in der ersten Wickellage WL1 das erste Bandstück 150 (gepunktet dargestellt) als Einfachband 114 gewickelt. Die zweite Wickellage WL2 wird ebenfalls mit dem ersten Bandstück 150 gewickelt. Die dritte Wickellage WL3 wird mit dem zweiten Bandstück 151 (weiß dargestellt) gewickelt. Die vierte Wickellage WL4 wird als Einfachband 114 ebenfalls mit dem zweiten Bandstück 151 gewickelt. Die Wickellagen WL2 und WL3 bilden eine Doppellage DL bzw. ein Mehrfachband 115. In der Doppellage DL sind die Bandstücke 150 und 151 über eine Bandlänge 152 miteinander überlappend verbunden, nämlich miteinander normalleitend verlötet, vgl. die Lötschicht 140. Beide Bandstücke 150, 151 sind mit ihren supraleitenden Schichten 4 radial nach innen orientiert bzw. mit ihren Substraten 3 radial nach außen orientiert, was im Betrieb einer Ablösung der supraleitenden Schichten 4 durch Lorentz-Kräfte vorbeugt. Bei dieser Bauform bildet die Doppellage DL ein Joint für die beiden Bandstücke 150, 151 aus, das genau die axiale Länge der dargestellten Sektion der NMR-Magnetspule 91 nutzt. Durch das Joint sind die Bandstücken 150, 151 elektrisch in Serie geschaltet. Die normalleitend verlötete Bandlänge 152 beträgt erfindungsgemäß mindestens 20 m, um den Übergangswiderstand gering zu halten. Sie nimmt in der Ausführungsform von Fig. 15a-15b genau eine (komplette) Doppellage über die gesamte axiale Länge der Spule bzw. Sektion ein, kann aber auch eine beliebige, ganzzahlige Anzahl von (kompletten) Doppellagen einnehmen, insbesondere genau zwei oder genau drei oder noch mehr (komplette) Doppellagen. Die Übergänge von einem Einfachband 114 zu einem Mehrfachband 115 erfolgen also stets an axialen Enden der Spule bzw. Sektion.

Man beachte, dass je nach verfügbarer, fehlerfreier Bandlänge auch zwei oder mehr Wickellagen als Einfachband 114 jeweils innen und/oder außen mit den Bandstücken 150, 151 gewickelt werden können.

Weiterhin können auch ein oder mehrere Bandstücke an beiden Enden (nicht jedoch in einem mittleren Teil) mit anderen Bandstücken normalleitend verlötet werden, um auf einfache Weise mehr als zwei Bandstücke in Serie zu schalten; die jeweilige normalleitend verlötete Bandlänge (mit mindestens 20 m Länge) bildet dann wieder mindestens eine Doppellage in der NMR-Magnetspule.

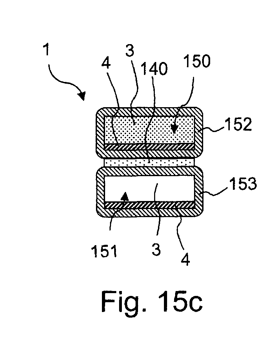

In Fig. 15c ist weiterhin ein Querschnitt durch die Supraleiterstruktur 1 im Bereich der Doppellage DL (vgl. hierzu Fig. 15b, Ebene XVc) dargestellt. Die Bandstücke 150, 151 sind jeweils in eine hochleitfähige Ummantelung 152, 153, insbesondere eine Kupferummantelung (etwa aus einer Kupferfolie von ca. 50 µm Dicke), eingehüllt. Die Ummantelungen 152, 153 werden miteinander verlötet, vgl. die Lotschicht 140, wobei die supraleitenden Schichten 4 jeweils radial nach innen (in Fig. 15c nach unten) orientiert sind. Insbesondere der linke und der rechte Seitenabschnitt der Ummantelung 153 und die unmittelbar auf den supraleitenden Schichten 4 bzw. an der Lotschicht 140 angeordneten Abschnitte der Ummantelungen 152, 153 tragen hier wesentlich zur ohmschen Verbindung der supraleitenden Schichten 4 der Bandstücke 150, 151 bei.

Die Substrate 3 der Bandstücke 150, 151 sind aus flexiblem, metallischen Material, etwa Stahlblech, gefertigt. Die supraleitende Schicht 4 umfasst typischerweise einen Hochtemperatur-Supraleitermaterial vom YBCO- oder BSCCO-Typ. Für die normalleitende Verlötung können insbesondere edelmetallhaltige und/oder kupferhaltige Lote verwendet werden.

## Patentansprüche

1. NMR-Spektrometer (131) mit einer NMR-Magnetspule (91), die zumindest in einer Sektion (121) Wicklungen umfasst mit einem Leiter aus einer Supraleiterstruktur (1), umfassend mehrere Bandstücke (2, 2a, 7a-7e, 8a-8d, 15) von bandförmigem Supraleiter,
wobei jedes Bandstück (2, 2a, 7a-7e, 8a-8d, 15) ein flexibles Substrat (3) und eine darauf abgeschiedene supraleitende Schicht (4) aufweist,
wobei die Bandstücke (2, 2a, 7a-7e, 8a-8d, 15) jeweils eine Länge von 20 m oder mehr aufweisen,
und wobei die Bandstücke (2, 2a, 7a-7e, 8a-8d, 15) miteinander verbunden sind,
wobei mindestens eines der Bandstücke (2, 2a, 7a-7e, 8a-8d, 15) als ein verkettetes Bandstück (2, 2a) ausgebildet ist,
und wobei ein jedes verkettete Bandstück (2, 2a) jeweils mit wenigstens zwei weiteren Bandstücken (7a-7e) derart verbunden ist, dass die weiteren Bandstücke (7a-7e) zusammen mit wenigstens 95% der gesamten Länge (L) des verketteten Bandstücks (2, 2a) überlappen, so dass elektrischer Strom zwischen dem verketteten Bandstück (2, 2a) und den gegenüberliegenden, parallelen, weiteren Bandstücken (7a-7e) ausgetauscht werden kann, wobei das verkettete Bandstück (2, 2a) in einem longitudinalen Bereich (LB2) um einen Spalt (6) zwischen zwei weiteren Bandstücken (7a-7e), die mit diesem verketteten Bandstück (2, 2a) überlappend verbunden sind, fehlerfrei ist.

2. NMR-Spektrometer (131) nach Anspruch 1, **dadurch gekennzeichnet, dass** die Supraleiterstruktur (1) wenigstens N verkettete Bandstücke (2, 2a) umfasst, mit N ≥ 5, bevorzugt N ≥ 20,
insbesondere wobei die N verketteten Bandstücke (2, 2a) aufeinanderfolgend miteinander verbunden sind, derart, dass zumindest eines der weiteren Bandstücke (7a-7e) eines jeden der verketteten Bandstücke (2, 2a) seinerseits ein verkettetes Bandstück (2, 2a) ist.

3. NMR-Spektrometer (131) nach Anspruch 2, **dadurch gekennzeichnet, dass** die Supraleiterstruktur (1) über die verketteten Bandstücke (2, 2a) in Erstreckungsrichtung (x) der verketteten Bandstücke (2, 2a) periodisch ausgebildet ist.

4. NMR-Spektrometer (131) nach einem der vorhergehenden Ansprüche, **dadurch gekennzeichnet, dass** in wenigstens einem verketteten Bandstück (2, 2a) wenigstens ein bekannter Fehlerbereich (FB) vorhanden ist, und dass wenigstens eines der weiteren Bandstücke (7a-7e), das mit diesem verketteten Bandstück (2, 2a) überlappt, so ausgewählt und/oder in longitudinaler Richtung positioniert ist, dass das weitere Bandstück (7a-7e) in einem weiteren longitudinalen Bereich (LB1) um den bekannten Fehlerbereich (FB) fehlerfrei ist, insbesondere in einem weiteren longitudinalen Bereich (LB1) von wenigstens 10 m zu beiden Seiten des bekannten Fehlerbereichs (FB).

5. NMR-Spektrometer (131) nach einem der vorhergehenden Ansprüche, **dadurch gekennzeichnet, dass** die Sektion (121) Wicklungen in mehreren radialen Wickellagen (WL1-WL6) umfasst, und dass Spalte (6) zwischen zwei weiteren Bandstücken (7a-7e), die mit demselben verketteten Bandstück (2, 2a) überlappend verbunden sind, in radial übereinander liegenden Wickellagen (WL1-WL6) azimutal voneinander beabstandet sind.

6. NMR-Spektrometer (131) nach einem der vorhergehenden Ansprüche, **dadurch gekennzeichnet, dass** die Sektion (121) mehrere axial benachbarte Wicklungen in wenigstens einer Wickellage (WL1-WL6) umfasst, und dass Spalte (6) in derselben Wickellage (WL1-WL6) azimutal voneinander beabstandet sind.

7. NMR-Spektrometer (131) nach einem der vorhergehenden Ansprüche, **dadurch gekennzeichnet, dass** die Sektion (121) zumindest eine Einfach-Band-Teilsektion (111, 113) aufweist, die mit einem einfachen, ununterbrochenen Bandstück gewickelt ist, und zumindest eine Mehrfach-Band-Teilsektion (112) aufweist, die mit einem Leiter aus der Supraleiterstruktur (1) gewickelt ist.

8. NMR-Spektrometer (131) nach Anspruch 7, **dadurch gekennzeichnet, dass** die Sektion (121) zwei axial äußere Einfach-Band-Teilsektionen (111, 113) aufweist, und eine axial mittlere Mehrfach-Band-Teilsektion (112), insbesondere wobei die axial mittlere Mehrfach-Band-Teilsektion (112) lediglich ein verkettetes Bandstück (2, 2a) aufweist.

9. NMR-Spektrometer (131) nach einem der vorhergehenden Ansprüche, **dadurch gekennzeichnet, dass** die Supraleiterstruktur (1) wenigstens zwei randseitige Bandstücke (8a-8d) aufweist,
wobei ein randseitiges Bandstück (8a-8d) jeweils mit einem verketteten Bandstück (2, 2a) derart verbunden ist, dass das verkettete Bandstück (2, 2a) im Wesentlichen mit der gesamten Länge des randseitigen Bandstücks (8a-8d) überlappt.

10. NMR-Spektrometer (131) nach einem der vorhergehenden Ansprüche, **dadurch gekennzeichnet, dass** ein Spalt (6) zwischen zwei weiteren Bandstücken (7a-7e), die mit demselben verketteten Bandstück (2, 2a) überlappend verbunden sind, eine Spaltbreite (SP) in Erstreckungsrichtung (x) der Bandstücke (7a-7e) von 5mm oder weniger, bevorzugt 2mm oder weniger aufweist, insbesondere wobei der Spalt (6) bei aneinander anstoßenden weiteren Bandstücken (7a-7e) geschlossen ausgebildet ist.

11. NMR-Spektrometer (131) nach einem der vorhergehenden Ansprüche,
**dadurch gekennzeichnet, dass** die Bandstücke (2, 2a, 7a-7e, 8a-8d, 15) der Supraleiterstruktur (1) außenseitig mit einer Shunt-Struktur (12) versehen sind, insbesondere teilweise oder vollständig von einer Shunt-Schicht (14; 14a, 14b) umhüllt sind.

12. NMR-Spektrometer (131) nach einem der vorhergehenden Ansprüche,
**dadurch gekennzeichnet, dass** die supraleitende Schicht (4) ein Hochtemperatur-Supraleitermaterial, insbesondere vom YBCO- oder BSCCO-Typ, enthält, und dass wenigstens eines der weiteren Bandstücke (7a-7e) ein Joint (125) zu einem Tieftemperatursupraleiter(=LTS)-Draht (123), enthaltend Filamente (128) eines LTS-Supraleitermaterials, ausbildet, wobei dieses weitere Bandstück (7a-7e) und der LTS-Draht (123) über wenigstens 1 m, bevorzugt wenigstens 10 m, in Längsrichtung des weiteren Bandstücks (7a) überlappen und mittels eines Lots (127) miteinander verlötet sind.

13. NMR-Spektrometer (131) nach einem der vorhergehenden Ansprüche,
**dadurch gekennzeichnet, dass** die supraleitende Schicht (4) ein Hochtemperatur-Supraleitermaterial, insbesondere vom YBCO- oder BSCCO-Typ, enthält, und dass die Magnetspule (91) wenigstens eine HTS-Sektion (121), die Wicklungen mit einem Leiter aus der Supraleiterstruktur (1) umfasst, und wenigstens eine LTS-Sektion (122), die Wicklungen aus einem LTS-Draht (124) umfasst, aufweist, insbesondere wobei die HTS-Sektion (121) und die LTS-Sektion (122) ineinander geschachtelt mit der HTS-Sektion (121) innen liegend angeordnet sind.

14. NMR-Spektrometer (131) nach einem der vorhergehenden Ansprüche,
**dadurch gekennzeichnet, dass** die Supraleiterstruktur (1) zumindest in einem Abschnitt einen M-fach-Band-Aufbau aufweist, mit M einer natürlichen Zahl und M≥3, in welchem mindestens eines der Bandstücke als ein mehrfach verkettetes Bandstück (2a) ausgebildet ist, wobei ein jedes mehrfach verkettete Bandstück (2a) jeweils mit M-1 Sets von jeweils wenigstens zwei weiteren Bandstücken (7a-7e) derart verbunden ist, dass die weiteren Bandstücke (7a-7e) eines jeden Sets zusammen mit wenigstens 95% der gesamten Länge (L) des mehrfach verketteten Bandstücks (2a) überlappen.

15. NMR-Spektrometer (131) mit einer NMR-Magnetspule (91), die zumindest in einer Sektion (121) solenoidförmig mehrlagig gewickelt ist und Wicklungen umfasst mit einem Leiter aus einer Supraleiterstruktur (1), umfassend mehrere in Serie geschaltete Bandstücke (150, 151) von bandförmigem Supraleiter, wobei jedes Bandstück (150, 151) ein flexibles, metallisches Substrat (3) und eine darauf abgeschiedene supraleitende Schicht (4) aufweist, und wobei in der Sektion mindestens zwei Bandstücke (150, 151) aneinander gestückelt sind, wobei diese Bandstücke (150, 151) auf einer Bandlänge (152) von mindestens 20 m miteinander normalleitend verlötet sind, wodurch diese Bandstücke (150, 151) elektrisch in Serie geschaltet sind, und wobei diese Bandstücke (150, 151) über die normalleitend verlötete Bandlänge (152) als eine komplette Doppellage (DL) oder mehrere komplette Doppellagen (DL) gewickelt sind, so dass Übergänge von einem Einfachband (114) zu einem Mehrfachband (115) an axialen Enden der Sektion (121) erfolgen.

## Claims

1. NMR spectrometer (131) with an NMR-magnet coil (91), of which at least one section (121) comprises windings of a conductor having a superconducting structure (1), the structure (1) comprising a plurality of band-segments (2, 2a, 7a-7e, 8a-8d, 15) of band-shaped superconductor,
each band-segment (2, 2a, 7a-7e, 8a-8d, 15) comprising a flexible substrate (3) and a superconducting layer (4) deposited thereon,
the band-segments (2, 2a, 7a-7e, 8a-8d, 15) each comprising a length of 20 m or more,
and the band-segments (2, 2a, 7a-7e, 8a-8d, 15) being jointed to each other, at least one of the band-segments (2, 2a, 7a-7e, 8a-8d, 15) being formed as a linked band-segment (2, 2a),
and each linked band-segment (2, 2a) being connected to at least two further band-segments (7a-7e) in such a way, that the further band-segments (7a-7e) together overlap with at least 95% of the total length (L) of the linked band-segment (2, 2a) such that an electric current may be exchanged between the linked band-segment (2, 2a) and the opposite, parallel further band-segments (7a-7e), wherein the linked band-segment (2, 2a) is free of defects in a longitudinal range (LB2) about a gap (6) between two further band-segments (7a-7e) which are overlappingly connected to the linked band-segment (2, 2a).

2. NMR spectrometer (131) according to claim 1, **characterized in that** the superconducting structure (1) comprises at least N linked band-segments (2, 2a), with N ≥ 5, preferably with N ≥ 20,
in particular wherein the N linked band-segments (2, 2a) are sequentially connected to each other such that at least one of the further band-segments (7a-7e) of each of the linked band-segments (2, 2a) is on its turn a linked band-segment (2, 2a).

3. NMR spectrometer (131) according to claim 2, **characterized in that** the superconducting structure (1) is constructed periodically via the linked band-segments (2, 2a) along the extension direction (x) of the linked band-segments (2, 2a).

4. NMR spectrometer (131) according to one of the preceding claims, **characterized in that** at least one of the linked band-segments (2, 2a) comprises at least one known defect area (FB), and that at least one of the further band-segments (7a-7e), overlapping with this particular linked band-segment (2, 2a), is selected and/or is positioned in a longitudinal direction in such a way, that the further band-segment (7a-7e) is free of defects in a further longitudinal range (LB1) about the known defect area (FB), in particular in a further longitudinal range (LB1) of at least 10 m on both sides of the known defect area (FB).

5. NMR spectrometer (131) according to one of the preceding claims **characterized in that** the section (121) comprises windings in a plurality of radial winding layers (WL1-WL6), and that gaps (6) between two further band-segments (7a-7e), which are overlappingly connected to the same linked band-segment (2, 2a), are azimuthally separated in winding layers (WL1-WL6) that radially lie on top of each other.

6. NMR spectrometer (131) according to one of the preceding claims **characterized in that** the section (121) comprises in at least one winding layer (WL1-WL6) a plurality of axially neighboring windings, and that gaps (6) located in the same winding layer (WL1-WL6) are azimuthally separated from each other.

7. NMR spectrometer (131) according to one of the preceding claims, **characterized in that** the section (121) comprises at least one single-band partial section (111, 113), being wound with a single continuous band-segment, and also comprises at least one multiple-band partial section (112), which is wound with a conductor having the superconducting structure (1).

8. NMR spectrometer (131) according to claim 7, **characterized in that** the section (121) comprises two axially outer single-band partial sections (111, 113), and an axially central multiple-band partial section (112), in particular wherein the axially central multiple-band partial section (112) comprises merely one linked band-segment (2, 2a).

9. NMR spectrometer (131) according to one of the preceding claims, **characterized in that** the superconducting structure (1) comprises at least two end band-segments (8a-8d),
wherein each band-segment (8a-8d) is connected to a linked band-segment (2, 2a) in such a way that the linked band-segment (2, 2a) essentially overlaps with the entire length of the end band-segment (8a-8d).

10. NMR spectrometer (131) according to one of the preceding claims, **characterized in that** a gap (6) between two further band-segments (7a-7e), which are overlappingly connected to the same linked band-segment (2, 2a) comprises a gap width (SP) in extension direction (x) of the band-segments (7a-7e) of 5mm or less, preferably of 2mm or less, in particular wherein the gap (6) is closed in case of further band-segments (7a-7e) that are in direct physical contact.

11. NMR spectrometer (131) according to one of the preceding claims, **characterized in that** the outer surfaces of the band-segments (2, 2a, 7a-7e, 8a-8d, 15) of the superconducting structure (1) comprise a shunt structure (12), in particular that the band segments (2, 2a, 7a-7e, 8a-8d, 15) are in part or completely encased by a shunt cover (14; 14a, 14b).

12. NMR spectrometer (131) according to one of the preceding claims, **characterized in that** the superconducting layer (4) comprises a high temperature superconductor material, in particular of the YBCO- or BSCCO-type, and that at least one of the further band-segments (7a-7e) forms a joint (125) to a wire of low temperature superconductor (=LTS) (123), containing filaments (128) of an LTS superconductor material, wherein this further band-segment (7a-7e) and the LTS wire (123) are overlappingly soldered to each other along at least 1 m, preferably at least 10 m, in longitudinal direction of the further band-segment (7a) by means of solder (127).

13. NMR spectrometer (131) according to one of the preceding claims, **characterized in that** the superconducting layer (4) comprises a high temperature superconductor material, in particular of the YBCO- or BSCCO-type, and that the magnet coil (91) comprises at least one HTS-section (121) comprising windings of a conductor having the superconducting structure (1), and at least one LTS-section (122) comprising windings of an LTS wire (124), in particular wherein the HTS-section (121) and the LTS-section (122) are stacked with the HTS-section (121) being arranged inwardly.

14. NMR spectrometer (131) according to one of the preceding claims, **characterized in that** the superconducting structure (1) comprises at least in one section an M-fold band-design, M being a natural number ≥3, in which at least one of the band-segments is constructed as a multiply-linked band-segment (2a), wherein each multiply-linked band-segment (2a) is connected to M-1 sets of at least two further band-segments (7a-7e) each, in such a way that the further band-segments (7a-7e) of each set in combination overlap with at least 95% of the total length (L) of the multiply-linked band-segment (2a).

15. NMR spectrometer (131) with an NMR-magnet coil (91), which is wound in at least one section (121) with a plurality of layers in the form of a solenoid and which comprises windings of a conductor having a superconducting structure (1) that comprises several band-segments (150, 151) of band-shaped superconductor connected in series, wherein each band-segment (150, 151) comprises a flexible, metallic substrate (3) and a superconducting layer (4) deposited thereon, and wherein at least two band-segments (150, 151) of the section are pieced together, wherein these band-segments (150, 151) are soldered to each other along a band length (152) of at least 20 m in a normally conducting way, thereby electrically connecting these band-segments (150, 151) in series, and wherein these band-segments (150, 151) are wound as a complete double layer (DL) or as a plurality of complete double layers (DL) along the band length (152) that is soldered in a normally conducting way such that the transitions from a single band (114) to a multiple band (115) are realized at axial ends of the section (121).

## Revendications

1. Spectromètre RMN (131) comportant une bobine électromagnétique RMN (91), qui comprend, au moins dans une section (121), des enroulements avec un conducteur d'une structure supraconductrice (1), comprenant plusieurs pièces de bande (2, 2a, 7a-7e, 8a-8d, 15) de supraconducteur en forme de bande,
chaque pièce de bande (2, 2a, 7a-7e, 8a-8d, 15) présentant un substrat souple (3) et une couche supraconductrice (4) déposée sur ce substrat,
les pièces de bande (2, 2a, 7a-7e, 8a-8d, 15) présentant chacune une longueur de 20 m ou plus,
et les pièces de bande (2, 2a, 7a-7e, 8a-8d, 15) étant reliées entre elles,
au moins une des pièces de bande (2, 2a, 7a-7e, 8a-8d, 15) étant réalisée sous la forme d'une pièce de bande chaînée (2, 2a),
et chaque pièce de bande chaînée (2, 2a) étant reliée à au moins deux autres pièces de bande (7a-7e) de telle manière que les autres pièces de bande (7a-7e) chevauchent ensemble au moins 95 % de la longueur totale (L) de la pièce de bande chaînée (2, 2a), de sorte qu'un courant électrique puisse être échangé entre la pièce de bande chaînée (2, 2a) et les autres pièces de bande (7a-7e) opposées parallèles, la pièce de bande chaînée (2, 2a) étant exempte de défauts dans une zone longitudinale (LB2) autour d'une fente (6) entre deux autres pièces de bande (7a-7e) qui sont reliées à chevauchement à cette pièce de bande chaînée (2, 2a).

2. Spectromètre RMN (131) selon la revendication 1, **caractérisé en ce que** la structure supraconductrice (1) comprend au moins N pièces de bande chaînées (2, 2a), avec N ≥ 5, de préférence N ≥ 20,
en particulier les N pièces de bande chaînées (2, 2a) étant reliées entre elles les unes à la suite des autres de telle manière qu'au moins une des autres pièces de bande (7a-7e) de chacune des pièces de bande chaînées (2, 2a) soit elle-même une pièce de bande chaînée (2, 2a).

3. Spectromètre RMN (131) selon la revendication 2, **caractérisé en ce que** la structure supraconductrice (1) est réalisée de façon périodique par les pièces de bande chaînées (2, 2a) dans la direction d'extension (x) des pièces de bande chaînées (2, 2a).

4. Spectromètre RMN (131) selon l'une des revendications précédentes, **caractérisé en ce qu'**au moins une zone de défaut connue (FB) est présente dans au moins une pièce de bande chaînée (2, 2a), et qu'au moins une des autres pièces de bande (7a-7e) qui chevauche cette pièce de bande chaînée (2, 2a) est sélectionnée et/ou positionnée dans la direction longitudinale de telle manière que l'autre pièce de bande (7a-7e) soit exempte de défauts dans une autre zone longitudinale (LB1) autour de la zone de défaut connue (FB), en particulier dans une autre zone longitudinale (LB1) d'au moins 10 m des deux côtés de la zone de défaut connue (FB).

5. Spectromètre RMN (131) selon l'une des revendications précédentes, **caractérisé en ce que** la section (121) comprend des enroulements en plusieurs couches d'enroulement radiales (WL1-WL6), et **en ce que** des fentes (6) entre deux autres pièces de bande (7a-7e) qui sont reliées à chevauchement à la même pièce de bande chaînée (2, 2a) sont distantes l'une de l'autre azimutalement dans des couches d'enroulement (WL1-WL6) superposées radialement.

6. Spectromètre RMN (131) selon l'une des revendications précédentes, **caractérisé en ce que** la section (121) comprend plusieurs enroulements adjacents axialement dans au moins une couche d'enroulement (WL1-WL6), et **en ce que** des fentes (6) dans la même couche d'enroulement (WL1-WL6) sont distantes l'une de l'autre azimutalement.

7. Spectromètre RMN (131) selon l'une des revendications précédentes, **caractérisé en ce que** la section (121) présente au moins une section partielle à bande simple (111, 113) qui est enroulée avec une pièce de bande simple ininterrompue, et au moins une section partielle à bande multiple (112) qui est enroulée avec un conducteur de la structure supraconductrice (1).

8. Spectromètre RMN (131) selon la revendication 7, **caractérisé en ce que** la section (121) présente deux sections partielles à bande simple (111, 113) axialement extérieures, et une section partielle à bande multiple (112) axialement centrale, en particulier la section partielle à bande multiple (112) axialement centrale présentant seulement une pièce de bande chaînée (2, 2a).

9. Spectromètre RMN (131) selon l'une des revendications précédentes, **caractérisé en ce que** la structure supraconductrice (1) présente au moins deux pièces de bande (8a-8d) situées sur le bord,
une pièce de bande (8a-8d) située sur le bord étant reliée chaque fois à une pièce de bande chaînée (2, 2a) de telle manière que la pièce de bande chaînée (2, 2a) chevauche sensiblement la longueur totale de la pièce de bande (8a-8d) située sur le bord.

10. Spectromètre RMN (131) selon l'une des revendications précédentes, **caractérisé en ce qu'**une fente (6) entre deux autres pièces de bande (7a-7e) qui sont reliées à chevauchement à la même pièce de bande chaînée (2, 2a) présente une largeur de fente (SP) dans la direction d'extension (x) des pièces de bande (7a-7e) de 5 mm ou moins, de préférence de 2 mm ou moins, en particulier la fente (6) étant fermée lorsque les autres pièces de bande (7a-7e) sont jointives.

11. Spectromètre RMN (131) selon l'une des revendications précédentes, **caractérisé en ce que** les pièces de bande (2, 2a, 7a-7e, 8a-8d, 15) de la structure supraconductrice (1) sont pourvues extérieurement d'une structure de shunt (12), en particulier sont enveloppées partiellement ou totalement par une couche de shunt (14 ; 14a, 14b).

12. Spectromètre RMN (131) selon la revendication 19, **caractérisé en ce que** la couche supraconductrice (4) contient un matériau supraconducteur à haute température, en particulier du type YBCO ou BSCCO, et **en ce qu'**au moins une des autres pièces de bande (7a-7e) forme une jonction (125) avec un fil supraconducteur à basse température (=LTS) (123), contenant des filaments (128) d'un matériau supraconducteur LTS, cette autre pièce de bande (7a-7e) et le fil LTS (123) se chevauchant sur au moins 1 m, de préférence au moins 10 m, dans la direction longitudinale de l'autre pièce de bande (7a) et étant brasés ensemble au moyen d'une brasure (127).

13. Spectromètre RMN (131) selon l'une des revendications précédentes, **caractérisé en ce que** la couche supraconductrice (4) contient un matériau supraconducteur à haute température, en particulier du type YBCO ou BSCCO, et **en ce que** la bobine électromagnétique (91) présente au moins une section HTS (121) qui comprend des enroulements avec un conducteur de la structure supraconductrice (1) et au moins une section LTS (122) qui comprend des enroulements formés d'un fil HTS (124), en particulier la section HTS (121) et la section LTS (122) étant emboîtées l'une dans l'autre avec la section HTS (121) située à l'intérieur.

14. Spectromètre RMN (131) selon l'une des revendications précédentes, **caractérisé en ce que** la structure supraconductrice (1) présente au moins dans une partie une structure de bandes multiple de M, M étant un entier naturel et M ≥ 3, dans laquelle au moins une des pièces de bande est réalisée sous la forme d'une pièce de bande (2a) à chaînage multiple, chaque pièce de bande (2a) à chaînage multiple étant reliée à M-1 ensembles d'au moins deux autres pièces de bande (7a-7e) de telle manière que les autres pièces de bande (7a-7e) de chaque ensemble chevauchent ensemble au moins 95 % de la longueur totale (L) de la pièce de bande (2a) à chaînage multiple.

15. Spectromètre RMN (131) comportant une bobine électromagnétique RMN (91) qui est enroulée en plusieurs couches en forme de solénoïde au moins dans une section (121) et qui comprend des enroulements avec un conducteur d'une structure supraconductrice (1), comprenant plusieurs pièces de bande (150, 151) couplées en série de supraconducteur en forme de bande, chaque pièce de bande (150, 151) présentant un substrat métallique souple (3) et une couche supraconductrice (4) déposée sur ce substrat, et au moins deux pièces de bande (150, 151) étant aboutées dans la section, ces pièces de bande (150, 151) étant brasées ensemble de manière normalement conductrice sur une longueur de bande (152) d'au moins 20 m, de sorte que ces pièces de bande (150, 151) soient couplées électriquement en série, et ces pièces de bande (150, 151) étant enroulées, par la longueur de bande (152) brasée de manière normalement conductrice, sous la forme d'une double couche complète (DL) ou de plusieurs doubles couches complètes (DL), de sorte que des transitions d'une bande simple (114) à une bande multiple (115) aient lieu aux extrémités axiales de la section (121).
